# FASCICULE DE BREVET EUROPEEN

(11) **EP 2 343 556 B1**
(45) Date de publication et mention de la délivrance du brevet: **24.10.2018**
(21) Numéro de dépôt: 10195946.8
(22) Date de dépôt: 20.12.2010
(51) Int. Cl.: G01P 15/08, G01P 15/125, B81C 1/00, B81B 3/00

(54) **Structure micromécanique comportant une partie mobile présentant des butées pour des déplacements hors plan de la structure et son procédé de réalisation**
Mikromechanische Struktur, die einen mobilen Teil mit Anschlägen für Bewegungen außerhalb der Planebene der Struktur umfasst, und ihr Herstellungsverfahren
Micromechanical structure including a mobile part equipped with stops for out-of-plane movements of the structure, and the method for making said structure

(30) Priorité: 22.12.2009 FR 0959412
(43) Date de publication de la demande: 13.07.2011
(73) Titulaire: Commissariat à l'Énergie Atomique et aux Énergies Alternatives, 75015 Paris (FR)
(72) Inventeur: Robert, Philippe, 38000 GRENOBLE (FR); Walther, Arnaud, 38000 GRENOBLE (FR)
(74) Mandataire: Ilgart, Jean-Christophe

(56) Documents cités:
- DE-A1-102006 011 545
- US-A- 4 882 933
- US-A- 5 181 156
- US-A1- 2004 245 586
- US-A1- 2005 277 219
- US-A1- 2006 144 143
- US-A1- 2009 152 654

## Description

### DOMAINE TECHNIQUE ET ART ANTÉRIEUR

La présente invention se rapporte aux systèmes microélectromécanique ou MEMS (Micro-Electro-Mechanical Systems) et aux systèmes nanoélectromécaniques ou NEMS (Nano-Electro-Mechanical Systems).

Ces systèmes comportent une structure active composée d'un élément fixe et d'un élément mobile, l'élément mobile étant suspendu par rapport à l'élément fixe et pouvant se déplacer par rapport à l'élément fixe. L'élément fixe est déposé sur un substrat et la structure active est recouverte d'un capot de protection.

Ces systèmes peuvent être utilisés comme capteurs, par exemple comme accéléromètre, gyromètre, magnétomètre, etc. L'élément mobile ou masse suspendue est mis(e) en mouvement par les forces extérieures, son déplacement par rapport à l'élément fixe est mesuré, par exemple sous la forme d'une variation de capacité. Ces mesures permettent de déduire par exemple les variations d'accélération d'un véhicule.

L'élément mobile est donc destiné à se déplacer, dans un plan et/ou hors plan. L'amplitude de déplacement de l'élément mobile est prise en compte pour dimensionner le système, notamment pour fixer les espaces entre les éléments. Cependant, il est nécessaire de limiter l'amplitude de déplacement pour différentes raisons :
- afin d'éviter la rupture mécanique du composant par exemple, lorsque le déplacement de l'élément mobile est dû à un choc,
- pour éviter que l'élément mobile, à un certain potentiel, ne rentre en court-circuit avec un autre élément du composant placé à un autre potentiel. Par exemple, dans le cas d'un accéléromètre à peignes interdigités, on souhaite éviter un court-circuit entre les peignes capacitifs mobiles et fixes en regard, et/ou,
- pour au moins réduire le risque de collage de la partie mobile sur le substrat, le capot de protection (ou packaging) ou toute autre partie fixe du composant, sous l'effet d'un choc par exemple.

A cet effet, on prévoit des butées, notamment pour limiter les déplacements hors plan de la partie mobile, et éviter la mise en contact avec certains éléments.

De telles butées sont par exemple connues du document US 5 750 420, celles-ci étant disposées entre le substrat ou un wafer support et la partie mobile. Ces butées limitent les mouvements vers le bas.

Le document US 2006/0144143 décrit des butées disposées entre le capot de protection et la partie mobile, obtenues par report d'un second wafer ou par dépôt d'une couche capot, et limitant les mouvements vers le haut.

Ces butées permettent donc de limiter le déplacement hors plan de la partie mobile.

Cependant, la réalisation de ces butées impose que l'entrefer entre la butée et l'élément mobile soit directement dépendant de l'entrefer MEMS/capot ou MEMS/substrat. Or, ces entrefers sont déterminés, soit par l'épaisseur du scellement, et par les tolérances sur l'épaisseur de cordon de scellement lors de la mise en oeuvre de la technologie de report, soit par le design du composant lui-même. En effet, la distance séparant la structure mobile du substrat ou du capot est déterminante au regard des capacités parasites MEMS/substrat ou MEMS/capot et influe également sur l'amortissement du MEMS.

Dans ce cas, l'entrefer est limité généralement à des hauteurs au moins égales à 2 µm ou 3 µm, avec des tolérances de l'ordre de 0,5 µm.

Cette limite inférieure est particulièrement dommageable dans le cas de structures très rigides, de type capteurs à détection par jauge de contrainte, par exemple de type jauge piézorésistive ou résonateur, qui ne tolèrent que de très faibles déplacements de la partie mobile. Dans ce cas, les déplacements tolérés (avant flambage ou rupture du composant) peuvent se limiter à quelques dizaines ou centaines de nanomètres. Ces déplacements maximaux sont donc bien en dessous des distances séparant le MEMS de son capot ou de son support. Les performances du MEMS et son encombrement ne sont donc pas optimaux.

En outre, dans le cas où le système comporte une butée haute et une butée basse, il peut être souhaitable que celles-ci soient symétriques, plus particulièrement que l'entrefer entre la structure mobile et les butées hautes et basses soient sensiblement identiques. Or, le procédé de réalisation de ces butées de l'état de la technique impose de ne pas réaliser les butées hautes et butées basses en même temps. En effet, les butées hautes sont réalisées par scellement d'un capot et les butées basses sont réalisées par gravure partielle du MEMS, ou les butées hautes et basses sont réalisées par report de wafers mais avec différents types de scellement et donc différents contrôles et différentes tolérances de l'entrefer. Il n'est alors pas possible de contrôler la symétrie entre butées hautes et basses.

Il existe également des capteurs et les actionneurs MEMS ou NEMS dont le déplacement de la partie mobile en fonctionnement normal est hors plan. Dans le cas des capteurs, par exemple les gyroscopes, ceux-ci comportent des électrodes de détection détectant leur rapprochement et leur éloignement, et dans le cas des actionneurs, ceux-ci comportent des électrodes d'actionnement qui, en leur appliquant une différence de potentiel se rapprochent, ou s'éloignent.

Or les procédés de l'état de la technique pour réaliser des capteurs ou actionneurs MEMS et NEMS hors plan sont complexes, longs et coûteux.

Le document C. Wang et al, "A novel CMOS out-of-plane accelerometer with fully differential gap-closing capacitance sensing electrodes", J. Micromech. Microeng., Vol 17, p 1275-1280, 2007 décrit un accéléromètre à détection hors-plan réalisé en technologie CMOS. Cet accéléromètre comporte un substrat et une partie active. La partie active comporte un cadre support suspendu par des poutres au- dessus du substrat et une masse mobile reliée au cadre support par des ressorts. La partie active comporte un empilement de couches de SiO₂ et d'aluminium, l'aluminium formant les électrodes.

La libération de la partie active par rapport au substrat et de la masse mobile par rapport au cadre support est obtenue par gravure chimique de l'aluminium. Or, pour ne pas graver les électrodes formées elles aussi en aluminium, il est nécessaire, lors du dépôt, d'encapsuler celles-ci. Par ailleurs pour obtenir une libération verticale, il faut, lors du dépôt, réaliser des vias « sacrificiels ». Outre la complexité du procédé de réalisation, les dimensions des entrefers verticaux sont limitées fortement par le procédé même. En outre, cette architecture limite le choix dans les dimensions des entrefers verticaux et horizontaux et de la partie active, puisqu'elles sont interdépendantes.

Le document DE 10 2006 011 545 décrit un procédé pour réaliser une structure comportant deux capteurs de quantités physiques différentes. L'un des capteurs comporte une partie fixe et une partie mobile dans le plan par rapport à la partie fixe, les parties fixe et mobile formant un condensateur à capacité variable. La partie mobile est formée uniquement dans une couche de silicium polycristallin et les faces de la partie fixe et de la partie mobile en regard formant le condensateur à capacité variable sont formées dans la même couche de silicium polycristallin.

Les documents US 2009 0152654 et US 2005 0277219 décrivent des structures similaires.

Le document US 4 882 933 décrit un procédé pour réaliser un accéléromètre micromécanique comprenant des butées à chevauchement formées dans une partie fixe et dans une partie mobile. Cependant, la structure semi-conductrice décrite dans ce document est différente de celle de la présente demande.

### EXPOSÉ DE L'INVENTION

C'est par conséquent un but de la présente invention d'offrir un procédé de réalisation simplifié d'un système MEMS ou NEMS comportant une structure active formée d'un empilement de couches sur un substrat d'une partie mobile et d'une partie fixe, les parties fixe et mobile comportant des surfaces en regard, ces surfaces pouvant formées, par exemple des butées, des électrodes de détection ou d'actionnement suivant l'application su système.

Le but précédemment énoncé est atteint par un procédé de réalisation d'un système MEMS ou NEMS tel que défini ci-dessus, comportant l'étape de libération de la structure active par gravure d'une couche sacrificielle dont le matériau est apte à être gravé de manière sélective par rapport au(x) matériau(x) de la structure active.

La couche sacrificielle, par exemple en oxyde, est située entre deux couches formant la structure active, la couche de la structure active, sur laquelle la couche sacrificielle est déposée, comportant des passages découvrant une autre couche sacrificielle, la couche sacrificielle remplissant ces passages et étant en contact avec l'autre couche sacrificielle. Les portions de la couche sacrificielle et de l'autre couche sacrificielle définissent, lorsqu'elles sont supprimées, au moins en partie la partie mobile de la couche active.

En d'autres termes, l'espace séparant les faces en regard est obtenu par dépôt d'une couche sacrificielle et l'espace séparant la partie fixe et la partie mobile dans la direction orthogonale au plan moyen de la structure est obtenu par gravure.

Ainsi, la libération de la partie mobile de la structure mobile peut se faire sans nécessiter de protéger par encapsulation le ou les matériaux de la structure active.

En outre, la libération verticale est obtenue par une simple étape de photolithogravure. Il n'est pas nécessaire de réaliser préalablement des vias « sacrificiels ». Il est alors possible d'avoir des faces en regard dont les dimensions latérales sont très faibles, de l'ordre du micromètre ce qui permet de limiter la surface des butées et donc les risques de collage. Cela permet également d'avoir des entrefers latéraux très faibles permettant d'obtenir des distances de butée latérales réduites.

Par ailleurs, grâce au procédé selon la présente invention, le choix des épaisseurs de la partie active est indépendant de celui de la couche sacrificielle.

Ces faces en regard peuvent former des électrodes de détection du déplacement hors plan de la partie mobile par rapport à la partie fixe, ou des électrodes d'actionnement déplaçant la partie mobile par rapport à la partie fixe.

Ou, dans un système MEMS ou NEMS obtenu grâce au procédé selon l'invention, les faces en regard peuvent former des butées pour limiter les mouvements hors plan et limiter les collages.

Les faces en regard peuvent être étroites pour limiter les surfaces en regard et ainsi diminuer les risques de collage.

Le procédé selon l'invention ne nécessite pas d'encapsulation des éléments.

On peut prévoir de réaliser des plots anti-collages dans au moins l'une des surfaces en regard. Par exemple ceux-ci sont réalisés dans la surface en regard supérieure et interviennent aussi bien lors d'un déplacement vers le haut, que lors d'un déplacement vers le bas.

Au lieu d'utiliser le substrat ou le capot, qui est nécessairement réalisé avant ou après respectivement la structure active, on conforme la structure active de sorte à ménager des zones en regard avec un entrefer déterminé entre la partie fixe et la partie mobile, ces zones en regard étant orientées de sorte à limiter les mouvements hors plan de la partie mobile.

En réalisant les butées au sein de la structure active, on obtient une très grande maîtrise de la valeur de l'entrefer qui est obtenu par dépôt de couche mince.

Avantageusement, dans le cas de butées hautes et basses, celles-ci peuvent être réalisées en même temps, elles présentent alors un entrefer identique.

Il est également possible de réaliser des butées qui forment à la fois des butées hors plan et des butées dans le plan, i.e. des butées latérales.

La présente invention a alors principalement pour objet un procédé de réalisation d'une structure micromécanique comportant un substrat et un empilement d'au moins une première et une deuxième couche active disposé sur le substrat, une partie mobile formée dans l'empilement et une partie fixe par rapport au substrat formée dans l'empilement, la partie mobile comportant des portions des au moins deux couches dudit empilement et la partie fixe comportant des portions des au moins deux couches dudit empilement, la partie fixe et la partie mobile comportant des faces en regard sensiblement parallèles à un plan moyen de la structure, ledit procédé, comportant : à partir d'un empilement d'au moins une première couche sacrificielle et de la première couche active, les étapes :
a) de structuration de la première couche active de sorte à révéler la première couche sacrificielle en au moins deux zones,
b) de formation d'une deuxième couche sacrificielle sur la première couche active, la deuxième couche sacrificielle recouvrant les dites zones révélant la première couche sacrificielle et traversant la première couche active et étant en contact avec ladite première couche sacrificielle dans lesdites zones,
c) de structuration de ladite deuxième couche sacrificielle de sorte à obtenir des portions de deuxième couche sacrificielle sur la première couche active au niveau des dites zones où la deuxième couche sacrificielle traverse la première couche active,
d) de formation d'une deuxième couche active sur les portions de la deuxième couche sacrificielle structurée et sur la première couche active avec laquelle elle est directement en contact,
   le matériau de la deuxième couche sacrificielle pouvant être gravé de manière sélective par rapport à ceux des première et deuxième couches actives.
e) de structuration des première et deuxième couches actives pour atteindre les portions de la deuxième couche sacrificielle structurée et la première couche sacrificielle,
f) d'élimination des portions de la deuxième couche sacrificielle structurée entre les faces en regard des première et deuxième couches actives,
g) d'élimination au moins partielle de la première couche sacrificielle libérant la partie mobile.

La présente invention a également pour objet un procédé de réalisation d'une structure micromécanique comportant un substrat et un empilement d'une première, d'une deuxième et d'une troisième couche active disposé sur le substrat, une partie mobile formée dans l'empilement et une partie fixe par rapport au substrat formée dans l'empilement, la partie mobile comportant des portions des au moins deux couches dudit empilement et la partie fixe comportant des portions des au moins deux couches dudit empilement, la partie fixe et la partie mobile comportant des faces en regard sensiblement parallèles à un plan moyen de la structure, ledit procédé comportant : à partir d'un empilement d'au moins une première couche sacrificielle et de la première couche active, les étapes :
a') de structuration de la première couche active de sorte à révéler la première couche sacrificielle en au moins deux zones,
b') de formation d'une deuxième couche sacrificielle sur la première couche active, la deuxième couche sacrificielle recouvrant les zones révélant la première couche sacrificielle et traversant la première couche active et étant en contact avec ladite première couche sacrificielle,
c') de structuration de ladite deuxième couche sacrificielle de sorte à obtenir au moins une première et une deuxième portion sur la première couche active, au niveau de certaines zones correspondant aux zones où les deux faces sont parallèles et où la deuxième couche sacrificielle traverse la première couche active,
d') de formation de la deuxième couche active sur les première et deuxième portions de la deuxième couche sacrificielle structurée et sur la première couche active, la deuxième couche active étant directement en contact avec la première couche active,
e') de structuration de la deuxième couche active au moins en certaines zones situées au niveau de la première portion de sorte à révéler ladite première portion,
f') de formation d'une troisième couche sacrificielle sur la deuxième couche active,
g') de structuration de la troisième couche sacrificielle de sorte à obtenir au moins une portion de ladite troisième couche sacrificielle recouvrant au moins partiellement la zone révélant la première portion de la deuxième couche sacrificielle et traversant la deuxième couche active et étant en contact avec ladite première portion de la deuxième couche sacrificielle,
h') de formation de la troisième couche active sur la au moins une portion de la troisième couche sacrificielle structurée et sur la deuxième couche active avec laquelle elle est directement en contact, les matériaux des deuxième et troisième couches sacrificielles pouvant être gravés de manière sélective par rapport à ceux des première, deuxième et troisième couches actives,
i') de structuration des trois couches actives pour atteindre les portions des deuxième et troisième couches sacrificielles et la première couche sacrificielle,
j') d'élimination des portions des deuxième et troisième couches sacrificielles structurées entre les faces en regard des première et deuxième couches actives et entre les deuxième et troisième couches actives,
k') d'élimination au moins partielle de la première couche sacrificielle libérant la partie mobile.

Il peut y a voir des portions gravées de première couche active qui ne comporteront pas de première et/ou de deuxième couche sacrificielle, car elles auront été retirées lors de la structuration, contrairement aux zones définies en a) ou a'). Ces portions gravées peuvent permettre par exemple une prise de contact ultérieure.

Par exemple, lors de l'étape c'), la première portion de la deuxième couche sacrificielle comporte une surface inférieure à celle de la deuxième portion, la première portion ayant une surface proche de la section de la portion de deuxième couche sacrificielle traversant la première couche active.

Avantageusement, le matériau de la deuxième couche et/ou de la troisième couche sacrificielle est un oxyde.

La formation de la deuxième couche active et/ou de la troisième couche active est, par exemple réalisée par croissance épitaxiale.

Les structurations des étapes a), c), a'), c'), e'), g') peuvent être obtenues par photolithographie et gravure. La libération de la partie mobile peut être obtenue au moyen d'acide fluorhydrique.

Entre les étapes d) et e), on peut réaliser une étape de formation d'au moins une zone implantée et entre les étapes e) et f), on réalise une étape de formation d'un contact métallique sur ladite au moins une zone implantée.

Chacune des couches actives de l'empilement peut être en silicium ou en SiGe. Le silicium ou le SiGe peut être soit monocristallin, soit polycristallin.

En variant, les couches actives de l'empilement sont en matériau métallique, par exemple en or, en cuivre ou en FeNi.

Dans une variante de réalisation, les structurations des étapes e) et i') sont obtenues par photolithographie et DRIE.

La première couche sacrificielle est par exemple est en oxyde de silicium, et fait partie d'un substrat SOI.

La présente invention a également pour objet une structure micromécanique obtenue par le procédé selon la présente invention, comportant un substrat et un empilement d'au moins deux couches disposé sur le substrat, une partie mobile formée dans l'empilement et une partie fixe par rapport au substrat formée dans l'empilement, la partie mobile comportant des portions des au moins deux couches dudit empilement et la partie fixe comportant des portions des au moins deux couches dudit empilement, la partie fixe et la partie mobile comportant des faces en regard sensiblement parallèles à un plan moyen de la structure, un matériau étant interposé entre la partie fixe et le substrat, ledit matériau étant différent de celui ou de ceux des couches de l'empilement formant les parties fixe et mobile, ledit matériau pouvant être gravé de manière sélective par rapport à celui ou à ceux des couches de l'empilement.

Par exemple, l'empilement comporte une première et une deuxième paire de faces en regard, les plans médians des deux paires étant confondus. L'empilement peut comporter une premier et une deuxième paires de faces en regard, la face de la première paire appartenant à la partie mobile étant dans un même plan que la face de la deuxième paire appartenant à la partie fixe et la face de la première paire appartenant à la partie fixe étant dans le même plan que la face de la deuxième paire appartenant à la partie mobile.

En variante, L'empilement peut comporter une première et une deuxième paire de faces en regard, les plans médians des deux paires étant distincts.

Dans un premier exemple de réalisation, en fonctionnement normal, la partie mobile est destinée à se déplacer dans une direction orthogonale au plan moyen de la structure et dans laquelle les faces en regard des parties fixe et mobile forment des électrodes, la partie fixe et la partie mobile étant à des potentiels différents.

Dans un autre exemple de réalisation, en fonctionnement normal, la partie mobile est destinée à se déplacer dans le plan moyen de la structure et dans laquelle les faces en regard des parties fixe et mobile forment des moyens de butée pour limiter le déplacement de la partie mobile dans une direction sensiblement perpendiculaire à l'empilement.

L'empilement peut alors comporter au moins une première couche du côté du substrat et une deuxième couche sur la première couche à l'opposé du substrat, et dans laquelle les moyens de butée comportent au moins une butée inférieure pour limiter le déplacement de la partie mobile vers le substrat et/ou au moins une butée supérieure pour limiter le déplacement de la partie mobile à l'opposé du substrat, la butée inférieure étant définie dans la première couche de la partie fixe et dans la deuxième couche de la partie mobile et la butée supérieure étant définie dans la deuxième couche de la partie fixe et dans la première couche de la partie mobile.

La butée inférieure peut comporter une surface dans la première couche de la partie fixe et une surface dans la deuxième couche de la partie mobile, les deux surfaces étant en regard et la butée supérieure comporte une surface dans la deuxième couche de la partie fixe et une surface dans la première couche de la partie mobile, les deux surfaces étant en regard.

Dans un exemple de réalisation, l'empilement peut comporter au moins une première, une deuxième et une troisième couche, et dans laquelle les moyens de butée comportent au moins une butée inférieure pour limiter le déplacement de la partie mobile vers le substrat et/ou au moins une butée supérieure pour limiter le déplacement de la partie mobile à l'opposé du substrat, la butée inférieure étant définie dans la première couche de la partie fixe et dans la deuxième couche de la partie mobile et la butée supérieure étant définie dans la deuxième couche de la partie mobile et dans la troisième couche de la partie fixe.

La partie fixe peut, par exemple comporter au moins trois doigts, et la partie mobile peut comporter au moins trois doigts, les doigts de la partie fixe et ceux de la partie mobile étant interdigités, dans laquelle la butée supérieure est formée par un des doigts de la partie mobile reçu entre deux doigts de la partie fixe, ledit doigt comportant deux éléments latéraux portant chacune une surface de la butée supérieure , chaque élément latéral étant reçu dans un logement de forme complémentaire formé par les deux doigts de la partie fixe de part et d'autre dudit doigt de la partie mobile, le fond de ces logements formant la surface en regard de la butée supérieure, et dans laquelle la butée inférieure est formée par un des doigts de la partie fixe reçu entre deux doigts de la partie mobile, ledit doigt comportant deux éléments latéraux portant chacune une surface, chaque élément latéral étant reçu dans un logement de forme complémentaire formé par les deux doigts de la partie mobile de part et d'autre dudit doigt de la partie fixe, le fond de ces logements formant la surface en regard.

La partie fixe peut comporter une face parallèle à une face de la partie mobile et en regard de ladite face, lesdites faces étant sensiblement orthogonales au plan de la structure, chaque face comportant au moins un doigt en saillie, le doigt de la partie mobile étant reçu dans un logement de la partie fixe de forme correspondante et le doigt de la partie fixe étant reçu dans un logement de la partie mobile de forme correspondante.

La structure micromécanique peut également comporter des butées pour limiter le déplacement de la partie mobile dans le plan, dites butées latérales.

Les logements peuvent former également lesdites butées latérales. Avantageusement, les doigts comportent une extrémité libre en forme de disque reçue dans un logement de forme correspondante.

Dans un exemple de réalisation, dans le as où la partie mobile est destinée à se déplacer dans une direction orthogonale au plan moyen de la structure, on peut prévoir que la partie mobile comporte au moins une masse mobile et deux poutres de part et d'autre de la masse mobile auxquelles la masse mobile est reliée par des segments, les poutre portant les électrodes, chacune des poutres coopérant avec une sous-partie de la partie fixe portant les électrodes en regard.

Dans un autre exemple de réalisation, dans le cas où la partie mobile est destinée à se déplacer dans une direction orthogonale au plan moyen de la structure, la partie mobile peut comporter une première et une deuxième électrode disposées côte à côte et la partie fixe comporte une première et une deuxième électrode disposées côte à côte, chacune en regard d'une électrode de la partie mobile, la première électrode de la partie mobile étant réalisée dans la première couche et la première électrode de la partie fixe étant réalisée dans la deuxième couche en regard de la première électrode de la partie mobile, et la deuxième électrode de la partie mobile étant réalisée dans la deuxième couche et la deuxième électrode de la partie fixe étant réalisée dans la première couche en regard de la deuxième électrode de la partie mobile. La partie mobile peut présenter une forme allongée dont une première extrémité longitudinale est montée sur un axe de torsion orthogonal à l'axe de la partie mobile et dont une deuxième extrémité porte les électrodes.

La structure micromécanique est par exemple apte à réaliser un dispositif de détection de mouvements hors plan ou de trimming d'un oscillateur.

Dans un autre exemple de réalisation, dans le cas où la partie mobile est destinée à se déplacer dans une direction orthogonale au plan moyen de la structure, la partie mobile comporte un logement formé d'une encoche de forme rectangulaire réalisée dans un bord de la partie mobile, la partie fixe étant reçue dans cette encoche et ayant une forme correspondante à celle de l'encoche, ses bords latéraux faisant face aux bords latéraux de la partie mobile, les électrodes étant portées par les bords latéraux de l'encoche et de l'électrode mobile, la partie mobile étant destinée à se déplacer dans une direction sensiblement orthogonale aux bords latéraux.

Les électrodes sont, par exemple portées par des doigts interdigités réalisés dans la première ou la deuxième couche.

La présente invention a également pour objet un capteur comportant au moins une structure micromécanique selon la présente invention. Le capteur peut être destiné à mesurer des déplacements hors plan de la partie mobile. Par exemple, le capteur peut former un accéléromètre hors plan. Le capteur peut comporter une jauge piézorésistive ou une jauge de contrainte.

La présente invention a également pour objet un actionneur destiné à déplacer la masse mobile le long d'une direction perpendiculaire au plan moyen.

### BRÈVE DESCRIPTION DES DESSINS

La présente invention sera mieux comprise à l'aide de la description qui va suivre et des dessins en annexes, sur lesquels :

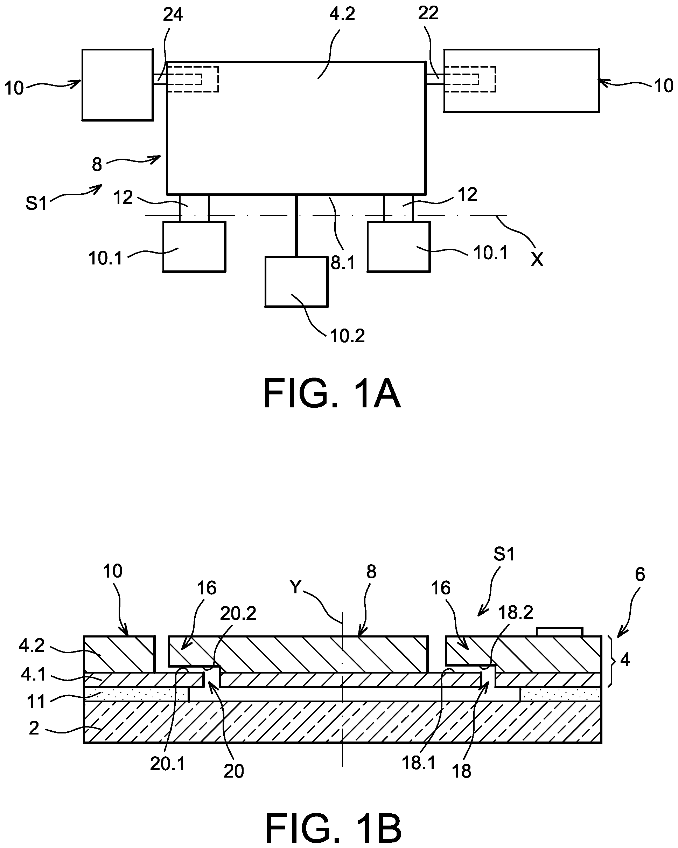

- la figure 1A est une vue de dessus d'un exemple d'une structure micromécanique selon la présente invention,

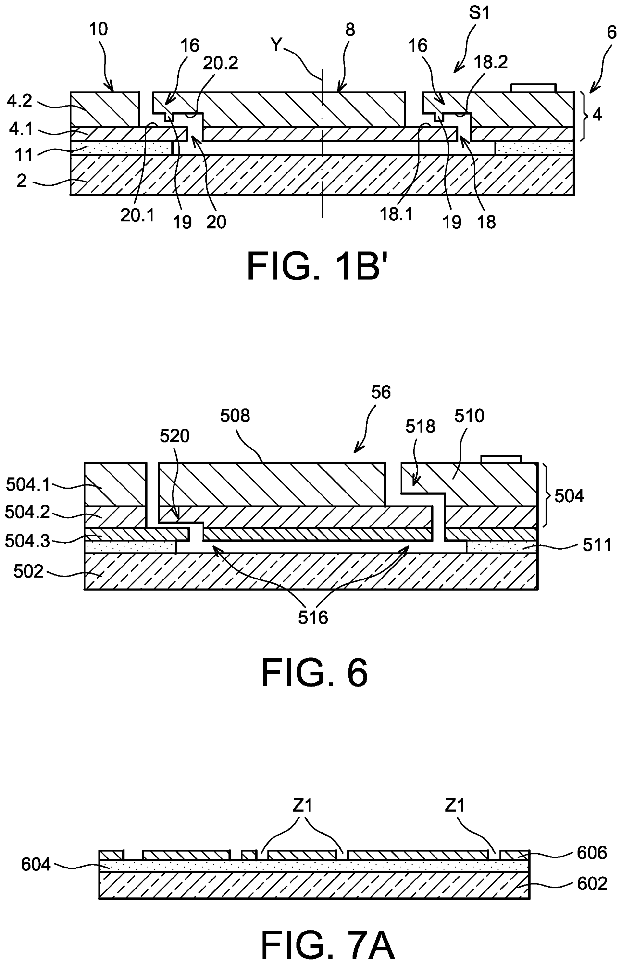

- la figure 1B est une vue en coupe transversale de la structure de la figure 1A,
- la figure 1B' est une vue en coupe transversale d'une variante de la figure 1A,
- la figure 2 est une vue de dessus d'un autre exemple de réalisation d'une structure micromécanique,
- la figure 3 est une vue de dessus d'un autre exemple de réalisation d'une structure micromécanique comportant des butées latérales,
- la figure 4 est une vue de dessus d'un autre exemple de réalisation d'une structure micromécanique comportant une variante dans les butées latérales,
- la figure 5 est une vue de dessus d'un autre exemple de réalisation d'une structure micromécanique,
- la figure 6 est une vue en coupe transversale d'une structure micromécanique comportant une structure active composée de trois couches,
- les figures 7A à 7G sont des représentations schématiques d'étapes d'un exemple de procédé de réalisation d'une structure micromécanique,
- les figures 8A à 8I sont des représentations schématiques d'étapes d'un exemple de procédé de réalisation d'une structure micromécanique dont la partie active comporte trois couches,
- la figure 9 est une vue de dessus et de côté d'une structure adaptée à la réalisation d'un gyromètre,
- la figure 10 est une vue de dessus et de côté d'une structure adaptée à la réalisation d'un accéléromètre vertical,
- les figures 11A et 11B sont des vues de dessus et de côté respectivement d'une structure adaptée à la réalisation d'électrodes de correction de biais en quadrature.

### EXPOSÉ DÉTAILLÉ DE MODES DE RÉALISATION PARTICULIERS

Dans la suite de la description, les structures micromécaniques décrites sont adaptées à la réalisation d'accéléromètre, mais il est bien entendu que la présente invention s'applique à la réalisation de tout autre type de capteur, par exemple à la réalisation de gyromètres et ou tout autre système utilisant une telle structure micromécanique.

Dans la description, MEMS désigne à la fois des systèmes microélectromécaniques et des systèmes nanoélectromécaniques.

Sur les figures 1A et 1B, on peut voir un premier exemple d'une structure microélectromécanique destinée à la réalisation d'un accéléromètre hors plan à jauge de contrainte.

Une structure micromécanique est dite hors plan, lorsque la direction de déplacement de sa partie mobile est orientée sensiblement perpendiculairement à son plan principal.

La structure micromécanique S1 des figures 1A et 1B comporte un substrat 2, sur lequel est disposé un empilement 4 d'au moins deux couches 4.1, 4.2, dans l'exemple représenté.

L'empilement 4 forme la structure active de la structure micromécanique, la structure active 6 comprenant une partie mobile 8 et une partie fixe 10.

La partie fixe 10 est fixe par rapport au substrat 2.

Selon la présente invention, une couche sacrificielle 11 est interposée entre le substrat 2 et l'empilement 4, cette couche 11 servant à la libération de la partie mobile 8. La couche sacrificielle 11 est réalisée en un matériau qui peut être gravé sélectivement par rapport aux matériaux de l'empilement formant la structure active, comme nous le verrons par la suite.

La partie mobile 8 est apte à se déplacer hors plan par rapport au substrat 2 sous l'effet de forces extérieures, ce sont donc les mouvements de la partie mobile 8 que l'on cherche à limiter.

Dans l'exemple représenté, la partie mobile 8 a la forme d'un rectangle.

La partie mobile 8 est maintenue en porte-à-faux au niveau d'un de ses grands côtés 8.1. Dans l'exemple représenté, le porte-à-faux est réalisé au moyen de deux éléments 12 reliant le grand côté 8.1 de la partie mobile et deux plots 10.1 de la partie fixe. Ces deux éléments forment également des charnières 12 permettant à la partie mobile 8 de se déplacer hors du plan, sensiblement autour d'un axe X.

Dans l'exemple représenté, des contacts électriques sont réalisés au niveau des plots 10.1.

En outre, la structure micromécanique comporte une jauge de contrainte 14 s'étendant entre la partie mobile 8 et un plot 10.2 de la partie fixe 10, par laquelle les déplacements de la partie mobile 8 sont captés. Un contact électrique est également réalisé au niveau du plot 10.2.

La structure micromécanique comporte également des moyens de butée 16 pour limiter l'amplitude des déplacements de la partie mobile 8 selon un axe Y perpendiculaire au substrat, plus particulièrement pour limiter l'amplitude des déplacements hors plan de la partie mobile 8. Les moyens de butée 16 sont formés entre la partie fixe 10 et la partie mobile 8.

Comme on peut le voir sur la figure 1B, les moyens de butée 16 sont formés par structuration des couches de l'empilement 4 de sorte à former des surfaces en regard perpendiculaires à l'axe Y.

Dans l'exemple représenté, les moyens de butée 16 comportent une butée supérieure 18 pour limiter les déplacements de la partie mobile en éloignement du substrat 2, i.e. vers le haut sur la figure 1B, et une butée inférieure 20 pour limiter les déplacements de la partie mobile en rapprochement du substrat 2, i.e. vers le bas sur la figure 1B.

Les moyens de butée peuvent comporter une ou plusieurs butées supérieures et/ou une ou plusieurs butées inférieures.

La butée supérieure 18 comporte une première surface 18.1 formée dans la première couche 4.1 de l'empilement 4 et orientée en éloignement du substrat, cette surface 18.1 étant portée par la partie mobile 8, et une deuxième surface 18.2 formée dans la deuxième couche 4.2 de l'empilement 4 et orientée en direction du substrat 2, cette deuxième surface 18.2 étant portée par la partie fixe 10. Les surfaces 18.1 et 18.2 se font face et la surface 18.1 est destinée à venir en contact avec la surface 18.2 en cas de déplacement excessif de la partie mobile 8 en éloignement du substrat 2.

Dans l'exemple représenté et comme on peut le voir sur la figure 1A, la surface 18.1 est formée sur un élément 22 en saillie d'un petit côté 18.2 de la partie mobile.

La butée inférieure 20 comporte une deuxième surface 20.2 formée dans la deuxième couche 4.2 de l'empilement 4 et orientée en direction du substrat, cette surface 20.2 étant portée par la partie mobile 8, et une première surface 20.1 formée dans la première couche 4.1 de l'empilement 4 et orientée en éloignement du substrat 2, cette première surface 20.1 étant portée par la partie fixe 10. Les surfaces 20.1 et 20.2 se font face et la surface 20.1 est destinée à venir en contact avec la surface 20.2 en cas de déplacement excessif de la partie mobile 8 vers le substrat 2.

Dans l'exemple représenté et comme on peut le voir sur la figure 1A, la surface 20.2 est formée sur un élément 24 en saillie d'un petit côté de la partie mobile, opposé à celui portant l'élément 22 portant la surface 18.1.

Nous allons maintenant expliquer le comportement de la structure micromécanique.

La partie mobile 8 se déplace autour de l'axe X en fonction des forces extérieures. La partie mobile 8 se rapproche et s'éloigne du substrat 2. Son déplacement sollicite la jauge de contrainte suspendue 14 réalisée dans la couche 4.1, les sollicitations de la jauge de contrainte 14 sont collectées et permettent la détermination des grandeurs recherchées.

En cas de choc, le mouvement de la partie mobile 8 a une grande amplitude en éloignement ou en rapprochement du substrat 2. La surface 18.1 ou 20.1 vient en contact avec la surface 18.2 ou 20.2 respectivement, limitant le déplacement de la partie mobile 8 et évitant un endommagement de celle-ci et des éléments environnants.

Sur la figure 1B', on peut voir une variante de la structure des figures 1A et 1B, comportant des plots anti-collages 19 en saillie des surfaces 18.2 et 20.2, destinés à limiter les risques de collage entre les surfaces 18.1, 18.2 et 20.1, 20.2.

Nous allons maintenant décrire un procédé de réalisation d'un système MEMS munie de moyens de butée hors plan.

On utilise, par exemple une structure SOI (Silicium on insulator) comportant un substrat 602 et une couche d'oxyde enterré BOX (Buried oxide), formant la couche sacrificielle 604 et une couche de silicium 606 formant une des couches de l'empilement actif. La couche sacrificielle 604 a une épaisseur de l'ordre de 1 µm et la couche de silicium 606 a une épaisseur de l'ordre de 0,2 µm.

Lors d'une première étape représentée sur la figure 7A, la couche 606 est structurée, par exemple par photolithographie et gravure. A la fin de cette étape, on effectue un décapage pour supprimer le masque de résine. On obtient alors des zones Z1 révélant la couche sacrificielle.

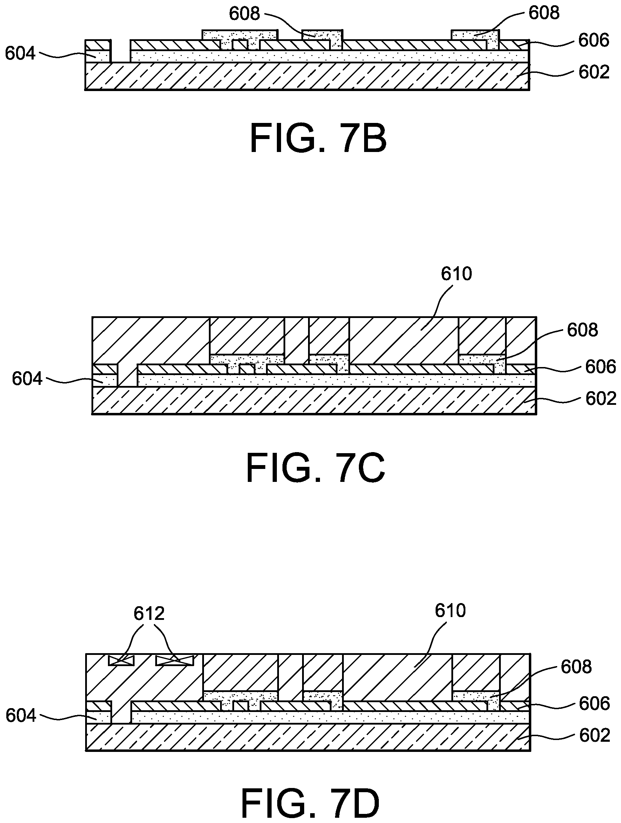

Lors d'une étape suivante représentée sur la figure 7B, une couche d'oxyde 608 est déposée sur la couche de silicium 606, d'une épaisseur de l'ordre de 0,3 µm. La couche d'oxyde 608 remplit les zones Z1 et entre en contact avec la couche sacrificielle 604.

On effectue ensuite une structuration de la couche 608 par photolithographie et gravure. A la fin de cette étape, on effectue un décapage pour supprimer les résidus de gravure. On obtient à la fin de cette étape au moins deux portions de couche d'oxyde traversant la première couche 606 et recouvrant celle-ci partiellement et des zones où la couche 606 est découverte. Dans l'exemple représenté, la structure comporte trois portions.

Lors d'une étape suivante représentée sur la figure 7C, on forme un dépôt d'une couche de silicium dopé 610 formant la deuxième couche de l'empilement actif. La couche 610 est obtenue par exemple, par croissance épitaxiale, et présente une épaisseur de l'ordre de 10 µm. Grâce à la mise en oeuvre d'au moins deux couches actives, il en résulte que la couche d'oxyde structurée 608 se trouve enterrée entre la première couche active 606 et la deuxième couche active 610.

Le silicium, dans ce cas, déposé par croissance épitaxiale sur les parties structurées de la couche d'oxyde 608 est polycristallin, tandis que celui déposé sur la couche active 606 est monocristallin. Les conditions de dépôt pourraient être telles que la couche 606 de silicium serait entièrement polycristalline.

On peut, à la fin de cette étape, effectuer un polissage mécano-chimique, permettant de planariser la marche due à la couche sacrificielle.

En variante, on peut effectuer une lithographie et une gravure partielle des portions 608 préalablement au dépôt de la couche 610 pour réaliser des plots anti-collage tels que représentés sur la figure 1B.

Lors d'une étape suivante représentée sur la figure 7D avantageuse, on génère des zones implantées 612 pour réaliser les contacts électriques.

Les zones implantées permettent de diminuer la résistance de contact dans le cas où le silicium obtenu par croissance épitaxiale est faiblement dopé.

Pour cela, on délimite les zones à implanter par photolithographie, puis on effectue un décapage. On réalise ensuite l'implantation des zones concernées, suivie d'un recuit pour activer les zones implantées 612.

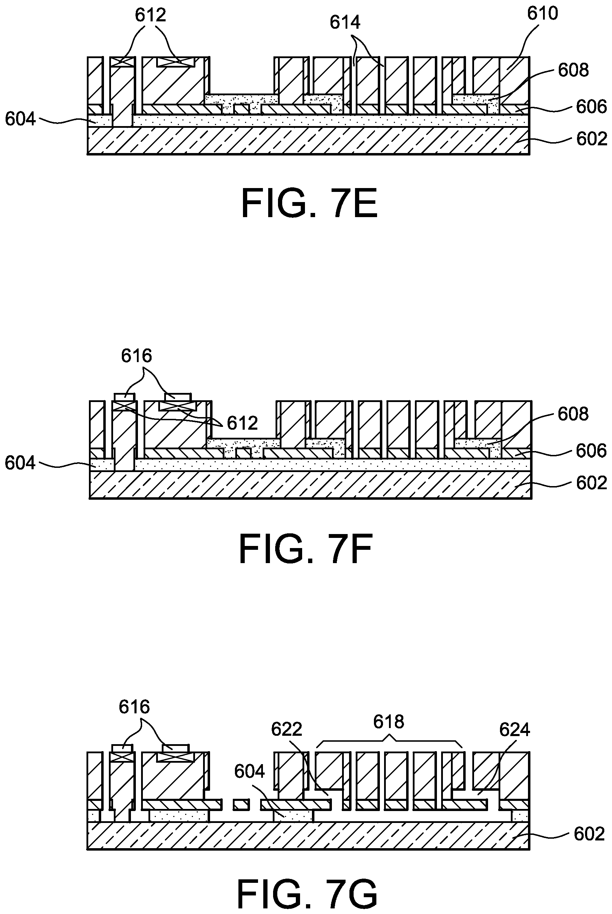

Lors d'une étape suivante représentée sur la figure 7E, on réalise la structure micromécanique. Par exemple, on délimite les zones à graver par photolithographie, puis on effectue une gravure verticale 614 dans l'épaisseur des deux couches actives 606, 610 jusqu'à la couche d'oxyde 608 et la couche sacrificielle 604, par exemple par DRIE (Deep Reactive Ion Etching) ou gravure profonde du silicium.

Lors d'une étape suivante représentée sur la figure 7F, on réalise les contacts électriques 616 au-dessus des zones implantées 612. Pour cela, on effectue un dépôt d'une couche métallique, on distingue les zones à supprimer et à conserver par photolithographie. On grave ensuite la couche métallique pour ne conserver que les contacts 614.

A la fin de cette étape, on effectue un décapage pour supprimer le masque de résine.

Enfin, lors d'une dernière étape représentée sur la figure 7G, on libère la partie mobile 618, en retirant la couche sacrificielle 604 et l'oxyde, par exemple au moyen d'acide fluorhydrique (HF) liquide et/ou vapeur. Il s'agit d'une gravure au temps. L'acide fluorhydrique est laissé au contact de la couche sacrificielle et de l'oxyde le temps nécessaire pour libérer la partie mobile tout en laissant la couche sacrificielle sous la partie fixe.

Le retrait des portions de couches d'oxyde permet de libérer horizontalement la partie mobile de la structure active.

On obtient alors, de manière simplifiée, une structure micromécanique dans laquelle les butées inférieure 622 et supérieure 624 sont réalisées au sein de la structure active. Ce procédé ne nécessite pas d'encapsuler les matériaux de la structure active pour éviter leur gravure par l'acide fluorhydrique. En outre, les gravures verticales sont obtenues facilement par photolithogravure et non par la réalisation de vias.

Dans le cas de l'utilisation d'un substrat SOI, la deuxième couche et les suivantes, le cas échéant, peuvent être réalisées par dépôt de silicium ou SiGe polycristallin.

On peut également partir d'un substrat standard, en déposant une couche sacrificielle d'oxyde par exemple, et en déposant une première couche de Si polycristallin ou SiGe polycristallin. On réalise la deuxième couche active, et les suivantes le cas échéant, également en silicium polycristallin ou SiGe polycristallin.

On peut également utiliser des couches en matériaux métalliques comme l'or, le cuivre, FeNi,... pour réaliser les couches actives.

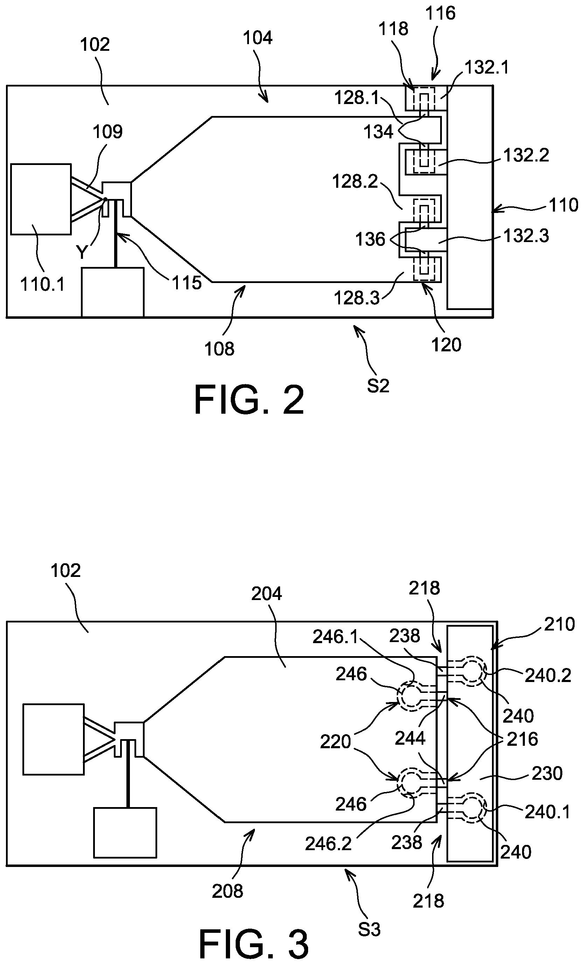

Sur la figure 2, on peut voir un deuxième exemple structure micromécanique S2 formant un accéléromètre dont la partie mobile est destinée, en fonctionnement normal, à se déplacer dans le plan.

La structure micromécanique comporte un substrat 102, un empilement 104 d'au moins deux couches formant la structure active de la structure micromécanique. L'empilement 104 est structuré de sorte à comporter une partie fixe 110 et une partie mobile 108.

Dans cet exemple, la partie mobile 108 a sensiblement la forme d'un pentagone composé d'un rectangle et d'un triangle isocèle, un petit côté du rectangle et la base du triangle étant commun.

La partie mobile 108 est suspendue par des poutres 109 au niveau d'un sommet du triangle isocèle à un plot 110.1 de la partie fixe 110.

La partie mobile 108 est apte à pivoter autour d'un axe Y perpendiculaire au plan de la feuille.

La structure micromécanique comporte également une jauge piézorésistive suspendue 115 pour capter les déplacements de la partie mobile 108.

La structure micromécanique comporte également des moyens de butée 116 disposés à l'opposé de l'axe de rotation Y par rapport à la partie mobile 108.

Dans l'exemple représenté, les moyens de butée 116 comportent des butées supérieure 118 et inférieure 120. Les butées 118 et 120 comportent des surfaces en regard portées par la partie mobile 108 et par la partie fixe 110 de l'empilement 104.

Une partie des moyens de butée 116 est réalisée sur un petit côté du rectangle.

La partie mobile 108 comporte en saillie du petit côté trois doigts 128.1, 128.2, 128.3.

La partie fixe comporte une barre 130 parallèle au petit côté et également trois doigts 132.1, 132.2, 132.3.

Le doigt 128.1 est disposé avec jeu entre les deux doigts 132.1 et 132.2, et le doigt 132.3 est disposé avec jeu entre les doigts 128.2 et 128.3.

Les doigts 128.1, 128.2, 128.3, 132.1, 132.2, 132.3 sont réalisés dans la deuxième couche de l'empilement 104.

Le doigt 128.1 comporte deux éléments 134 en saillies de ses bords latéraux formés dans la première couche 104.1 de l'empilement 104.

Chacun des deux éléments 134 se place sous un doigt 132.1, 132.2 comme le montrent le pointillé. Les doigts 132.1, 132.2 et les éléments 134 portent des surfaces en regard, formant une butée supérieure.

Le doigt 132.3 de la partie fixe 110 comporte deux éléments 136 en saillies de ses bords latéraux formés dans la première couche de l'empilement 104.

Chacun des deux éléments 136 se place sous un doigt 128.2, 128.3 comme le montre les pointillés. Les doigts 128.2, 128.3 et les éléments 136 portent des surfaces en regard, formant une butée inférieure.

Le fonctionnement des butées est similaire à celui de l'exemple des figures 1A et 1B.

Sur la figure 3, on peut voir un autre exemple de réalisation d'une structure micromécanique S3.

La structure micromécanique S3 est très proche de celle de la structure S2 de la figure 2. Elle comporte un substrat 202, un empilement 204 d'au moins deux couches formant la structure active de la structure micromécanique. L'empilement est structuré de sorte à comporter une partie fixe 210 et une partie mobile 208.

La structure micromécanique S3 diffère de la structure S2 par ses moyens de butée 216. Ceux-ci forment à la fois des butées supérieure 218 et inférieure 220 et des butées latérales.

La butée supérieure comporte deux doigts 238 en saillie du petit côté du rectangle formé dans la première couche 204 de l'empilement, ces doigts sont sensiblement orthogonaux au petit côté du rectangle. Ces deux doigts sont, dans l'exemple représenté, disposés aux deux extrémités du petit côté.

La barre 230 de la partie fixe comporte deux logements 240 réalisés dans la première couche 204.1 de l'empilement et recevant chacun un doigt 238 de la partie mobile 208. Les logements 240 ont une forme complémentaire à celle des doigts 238. Le logement 240 comporte un fond supérieur formé dans la deuxième couche 204 de l'empilement 204 et une paroi latérale 240.1 formée dans la première couche de l'empilement 204.

Dans l'exemple représenté, les doigts 238 comportent une extrémité en forme de disque raccordée au petit côté par une poutre, la largeur de la poutre étant inférieure au diamètre du disque. Les logements 240 ont donc une forme complémentaire à celle des extrémités des doigts 238. Les butées circulaires assurent un arrêt en translation dans les deux sens. En considérant la structure dans sa position horizontale, les butées circulaires réalisent une butée vers la gauche et vers la droite et vers l'avant et vers l'arrière. En outre, le contact entre les doigts et les logements dans lesquels les doigts sont reçus, est ponctuel ce qui limite les risques de collage.

La butée inférieure 220 comporte également deux doigts 244 en saillie de la barre 230, formés dans la première couche de l'empilement 204, ces doigts 244 sont sensiblement orthogonaux à l'axe de la barre 230. Ces deux doigts 244 sont, dans l'exemple représenté, entre les deux logements 240.

La partie fixe comporte deux logements 246 réalisés dans la première couche de l'empilement 204 et recevant avec chacun un doigt 244 de la partie fixe. Les logements 246 ont une forme complémentaire à celle des doigts 244. Les logements 246 comportent un fond inférieur formé dans la deuxième couche de l'empilement 204 et une paroi latérale 246.1 formée dans la première couche de l'empilement 204.

Dans l'exemple représenté, les doigts 244 comportent une extrémité en forme de disque raccordé à la barre 230 par une poutre, la largeur de la poutre étant inférieure au diamètre du disque. Les logements 246 ont donc une forme complémentaire.

Il est bien entendu que ni le nombre de doigts des butées, ni leur emplacement n'est limitatif. En outre, la butée inférieure peut comporter plus ou moins de doigts que la butée supérieure.

Nous allons maintenant expliquer le fonctionnement des butées.

Par exemple, lorsqu'un choc provoque un déplacement excessif de la partie mobile vers le haut, les doigts 238, plus particulièrement les disques et une partie des poutres entrent en contact avec le fond supérieur des logements 240.

Lorsqu'un choc provoque un déplacement excessif de la partie mobile vers le bas, les doigts 244, plus particulièrement les disques et une partie des poutres entrent en contact avec le fond inférieur des logements 246.

Lorsqu'un choc provoque un déplacement excessif de la partie mobile latéralement (de haut en bas sur la représentation de la figure 3), au moins l'un des doigts 238, 244 entre en contact avec la paroi latérale 240.1, 246.1 de son logement, limitant donc le déplacement latéral.

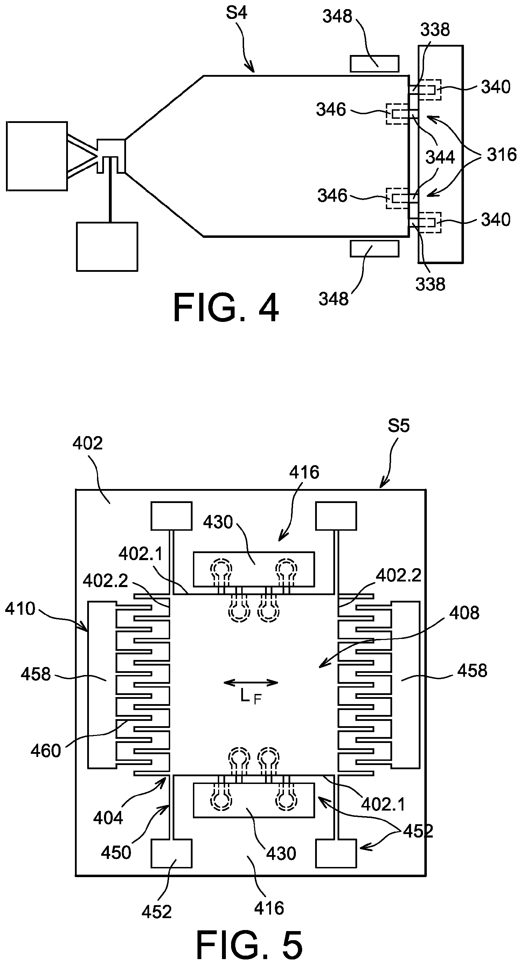

Sur la figure 4, on peut voir une variante de réalisation S4 de la structure micromécanique S3 de la figure 3. Dans cette structure micromécanique S4, les butées latérales sont distinctes des butées supérieure et inférieure.

Les moyens de butée 316 de la structure micromécanique S4 comportent des doigts 338, 344 de forme rectangulaire reçus dans des logements 340, 346 de forme correspondante respectivement.

En outre, la structure micromécanique S4 comporte des butées latérales 348 formées dans les parties fixes et disposées en regard des grands côtés du rectangle. Lorsqu'un choc provoque un déplacement excessif de la partie mobile latéralement, l'un des grand côté en fonction de l'orientation du déplacement entre en contact avec l'une des butées latérales 348, limitant alors le déplacement latérale.

Cette réalisation simplifie la réalisation des moyens de butée 316.

Sur la figure 5, on peut voir un autre exemple de structure micromécanique S5 destinée à la réalisation d'un accéléromètre de type peignes interdigités.

La structure S5 comporte un substrat 402, un empilement 404 d'au moins deux couches formant la structure active de la structure micromécanique. L'empilement est structuré de sorte à comporter une partie fixe 410 et une partie mobile 408.

La partie mobile 408 a la forme d'un rectangle muni de deux grands côtés 408.1 et de deux petits côtés 408.2.

La partie mobile est suspendue au-dessus du substrat par quatre ressorts de flexion 450 situés aux quatre coins de la partie mobile 408 et se raccordant à quatre plots 452 de la partie fixe. La partie mobile 408 comporte également des dents 454 en saillie de ses grands côtés.

La partie fixe 410 comporte deux barres 458 disposées de part et d'autre de la partie mobile 408 et parallèles aux grands côtés 402.2. Les barres 458 comportent également des dents 460 en saillie.

Les dents 454 et 460 sont interdigitées et présentent des faces parallèles en regard.

Le déplacement de la partie mobile 408, en fonctionnement normal, est symbolisé par la flèche F.

La structure micromécanique S5 comporte également des moyens de butée 416. Ceux-ci sont de forme similaire à ceux de la structure micromécanique S3 de la figure 3. Cependant les moyens de butée 416 sont situés sur les deux petits côtés 402.1 de la partie mobile 408. En effet, contrairement à la structure micromécanique S3, les déplacements hors plan de la partie mobile 408 ne sont pas limités à une extrémité par un axe de rotation, les ressorts de flexion ne sont pas aptes à limiter suffisamment de tels déplacements.

La partie fixe 410 comporte deux barres 430 chacune en face d'un petit côté. La partie mobile 408 comporte des doigts 238 reçus dans des logements 440 de la partie fixe 410, et la partie fixe comporte des doigts 444 reçus dans des logements 446 de la partie mobile 408. Les moyens de butée 416 forment à la fois des butées supérieure, inférieure et latérale.

Le fonctionnement est similaire à celui de la structure micromécanique S3.

Sur la figure 6, on peut voir une variante S6 de la structure micromécanique S1 des figures 1A et 1B. La structure micromécanique S6 diffère de la structure micromécanique S1 par le fait que l'empilement comporte trois couches.

La présente invention n'est pas limitée à la mise en oeuvre d'un empilement de deux couches pour réaliser les moyens de butée. L'empilement peut comporter n couches, n étant égal ou supérieur à 2. En outre, les couches peuvent être d'épaisseur différente et en matériau différent.

La mise en oeuvre d'un empilement à au moins trois couches permet de réaliser des butées à différents niveaux de la couche active et/ou avec différentes valeur d'entrefer.

La structure micromécanique S6 comporte un substrat 502, un empilement 504 de trois couches 504.1, 504.2, 504.3 formant la structure active de la structure micromécanique et des moyens de butée 516. L'empilement est structuré de sorte à comporter une partie mobile 508 et une partie fixe 510.

Selon la présente invention, une couche sacrificielle 511 est interposée entre le substrat 502 et la couche 504.1, dont le matériau peut être gravé sélectivement par rapport aux matériaux de la structure active.

Dans cet exemple de réalisation, les couches 504.1, 504.2, 504.3 sont d'épaisseur différente, la couche 504.1 ayant l'épaisseur la plus faible et la couche 504.3 ayant l'épaisseur la plus grande.

Dans l'exemple représenté, la butée supérieure 518 comporte une face de la partie mobile 508 formée par la deuxième couche 504.2 et une face de la partie fixe 510 formée dans la troisième couche 504.3.

La butée inférieure 520 comporte une face de la partie mobile 508 formée dans la deuxième couche 504.2 et une face de la partie fixe 510 formée par la première couche 504.3.

On obtient alors un très bon contrôle de la hauteur de l'entrefer des butées verticales, puisque la hauteur est définie par l'épaisseur des couches minces.

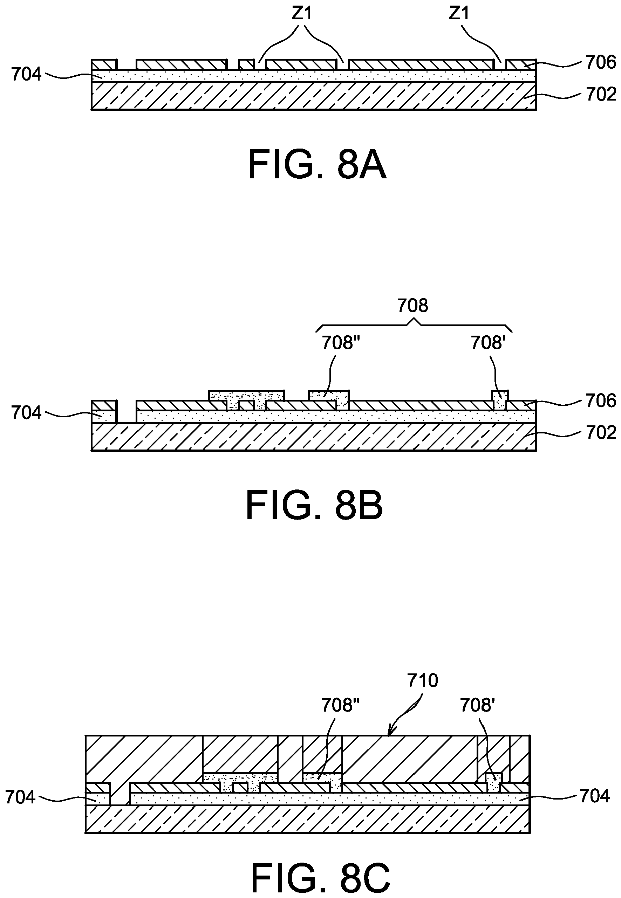

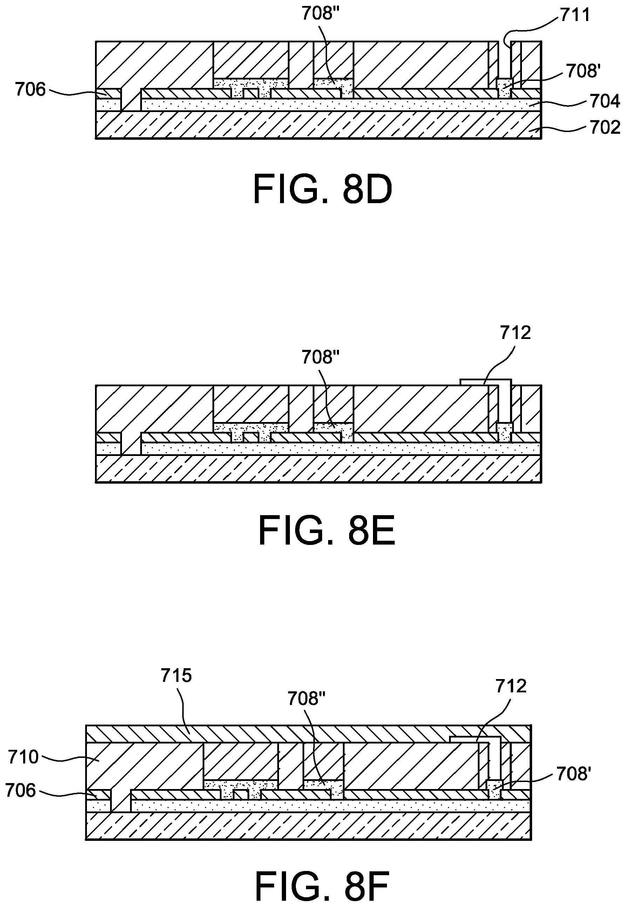

Nous allons maintenant décrire un exemple de procédé de réalisation d'un système MEMS, dans lequel la partie active comporte trois couches et dont les étapes sont schématisées sur les figures 8A à 8I.

On utilise, par exemple une structure SOI (Silicium on insulator) comportant un substrat 702et une couche d'oxyde (BOX :Buried oxide), formant la couche sacrificielle 704 et une couche de silicium 706 formant une des couches de l'empilement actif. La couche sacrificielle 704 a une épaisseur de l'ordre de 1 µm et la couche de silicium 706 a une épaisseur de l'ordre de 0,2 µm.

Lors d'une première étape représentée sur la figure 8A, la couche 706 est structurée, par exemple par photolithographie et gravure. A la fin de cette étape, on effectue un décapage pour supprimer le masque de résine. On obtient alors des zones Z1 révélant la couche sacrificielle 704.

Lors d'une étape suivante représentée sur la figure 8B, une couche d'oxyde 708 est déposée sur la couche de silicium 706, d'une épaisseur de l'ordre de 0,3 µm. La couche d'oxyde 708 remplit les zones Z1 et entre en contact avec la couche sacrificielle 704.

On effectue ensuite une structuration de la couche 708 par photolithographie et gravure. A la fin de cette étape, on peut effectuer un décapage pour supprimer le masque de gravure. On obtient à la fin de cette étape au moins deux des portions de couche d'oxyde traversant la première couche 706 et recouvrant celle-ci partiellement et des zones où la couche 706 est découverte. Dans l'exemple représenté, il ya trois portions d'oxyde.

Dans l'exemple représenté, une des portions 708' présente une dimension horizontale sensiblement égale à celle de la zone Z1 qu'elle recouvre. L'autre portion 708" permettra la formation de la butée inférieure. Cependant on peut prévoir que toutes les portions d'oxyde aient les mêmes dimensions.

En variante, on peut effectuer une lithographie et une gravure partielle de la portion 708'préalablement au dépôt de la couche 710 pour réaliser des plots anti-collages.

Lors d'une étape suivante représentée sur la figure 8C, on forme un dépôt d'une couche de silicium dopé 710 formant la deuxième couche de l'empilement actif. La couche 710 est obtenue par exemple, par croissance épitaxiale, et présente une épaisseur par exemple de 5 µm.

Le silicium déposé par croissance épitaxiale sur les parties structurées de la couche d'oxyde 708 est polycristallin, tandis que celui déposé sur la couche active 706 est monocristallin.

On peut, à la fin de cette étape, effectuer un polissage mécano-chimique, permettant de planariser la marche due à la couche sacrificielle et aux vitesses de croissance différentes entre le silicium monocristallin et le silicium polycristallin.

Lors d'une étape suivante représentée sur la figure 8D, on effectue une photolithographie de la zone de la couche active 710 au niveau de la portion 708', puis on grave cette zone jusqu'à atteindre la portion d'oxyde 708', formant ainsi un canal vertical 711 dans la couche active 710.

On réalise ensuite un dépôt d'une nouvelle couche d'oxyde 712 et de structuration de celle-ci. Le canal 711 est rempli d'oxyde. A la fin de la gravure, il reste une portion au dessus de la portion 708' et reliée à la portion 708', qui permettra la formation de la butée supérieure. Il est également possible d'effectuer une lithographie et une gravure partielle de cette portion préalablement au dépôt de la couche 715, qui sera décrite ci-dessous, pour réaliser des plots anti-collage.

L'oxyde de cette deuxième couche peut être identique ou différent de celui de la première couche.

Lors d'une étape suivante représentée sur la figure 8F, on réalise un dépôt 715 de silicium, par exemple par croissance épitaxiale, formant la troisième couche active. L'épaisseur de la couche 715 est par exemple d'environ 3 µm.

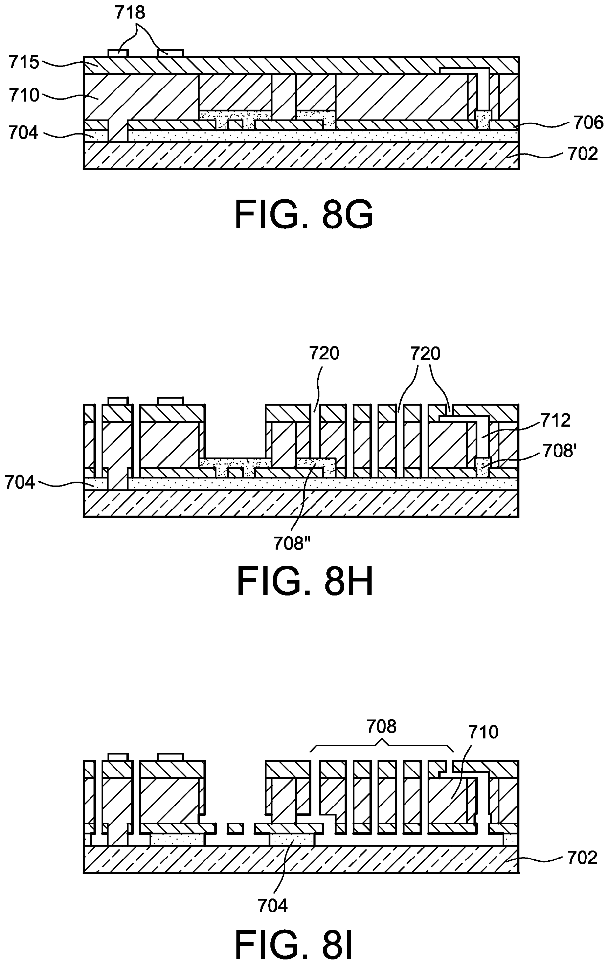

Lors d'une étape suivante représentée sur la figure 8G, on effectue un dépôt d'une couche métallique 718. Par photolitographie, on délimite les contacts électriques Puis on effectue une gravure pour former ces contacts. On pourrait prévoir de réaliser des zones implantées.

Lors d'une étape suivante représentée sur la figure 8H, on réalise la structure micromécanique. Par exemple, on délimite les zones à graver par photolithographie, puis on effectue des gravures verticales 720 dans l'épaisseur des trois couches actives 706, 710, 715 jusqu'aux portions d'oxyde 708', 708" et 712 et jusqu'à la couche sacrificielle 704, par exemple par DRIE (Deep Reactive Ion Etching) ou gravure profonde du silicium.

Enfin, lors d'une dernière étape représentée sur la figure 8I, on libère la partie mobile 708, en retirant la couche sacrificielle 704 et les portions d'oxyde, par exemple au moyen d'acide fluorhydrique liquide et/ou vapeur. Il s'agit d'une gravure au temps. L'acide fluorhydrique est laissé au contact de la couche sacrificielle et de l'oxyde le temps nécessaire pour libérer la partie mobile tout en laissant de la couche sacrificielle sous la partie fixe.

Le retrait des portions de couches d'oxyde 708" et 712 permet de libérer les butées supérieure et inférieure.

On obtient alors, de manière simplifiée, une structure micromécanique dans laquelle les butées inférieure et supérieure sont réalisées au sein de la structure active dans deux plans différents.

Comme dans le cas d'une structure à deux couches, dans le cas de l'utilisation d'un substrat SOI, la deuxième couche et les suivantes, le cas échéant, peuvent être réalisées par un dépôt de silicium ou SiGe polycristallin.

On peut également partir d'un substrat standard, en déposant une couche sacrificielle d'oxyde par exemple, et en déposant une première couche de silicium polycristallin ou SiGe polycristallin. On réalise la deuxième couche active, et les suivantes le cas échéant, également en silicium polycristallin ou SiGe polycristallin.

On peut également utiliser des couches en matériaux métalliques comme l'or, le cuivre, FeNi,... pour réaliser les couches actives.

Il est bien entendu que toutes les méthodes de structuration des différentes couches sont applicables.

En outre, on peut réaliser des butées présentant un entrefer symétrique ou dissymétrique dans les deux sens de déplacement verticaux, puisque les butées sont fabriquées en deux temps

Enfin, il est possible de combiner les butées verticales et les butées latérales et ainsi obtenir des butées suivant trois axes de l'espace en utilisant une technologie de surface ne nécessitant aucun report de wafer.

Les structures micromécaniques selon la présente invention peuvent notamment être mises en oeuvre dans des micro-capteurs MEMS ou NEMS, des capteurs inertiels (accéléromètre, gyromètre), des magnétomètres MEMS ou NEMS à détection piézorésistive ou capacitive, des micro-actionneurs MEMS (scanner optique,...), dans des systèmes de conversion d'énergie mécanique en énergie électrique.

La présente invention s'applique également à la réalisation de capteurs et actionneurs MEMS et NEMS utilisant des électrodes de détection capacitives horizontales pour la détection de mouvements verticaux et/ou de moyens d'actionnement générés par une force verticale.

Par exemple, de tels systèmes MEMS ou NEMS peuvent être utilisés pour réaliser des capteurs inertiels, comme des accéléromètres selon la direction Z à détection capacitive ou autre et/ou utilisant un asservissement du mouvement en détection selon Z, ou des gyroscopes X/Y à détection capacitive ou autre, et pouvant utiliser un asservissement du mouvement de détection selon Z. Les électrodes horizontales réalisées suivant les procédés décrits peuvent également servir à l'excitation et/ou à l'ajustement de la fréquence de résonance (trimming) électrostatique du résonateur à mouvement hors plan, ou à des électrodes de compensation de biais de quadrature dans le cas de gyromètre.

De tels systèmes MEMS ou NEMS peuvent également être utilisés pour réaliser des actionneurs utilisant un mouvement hors plan.

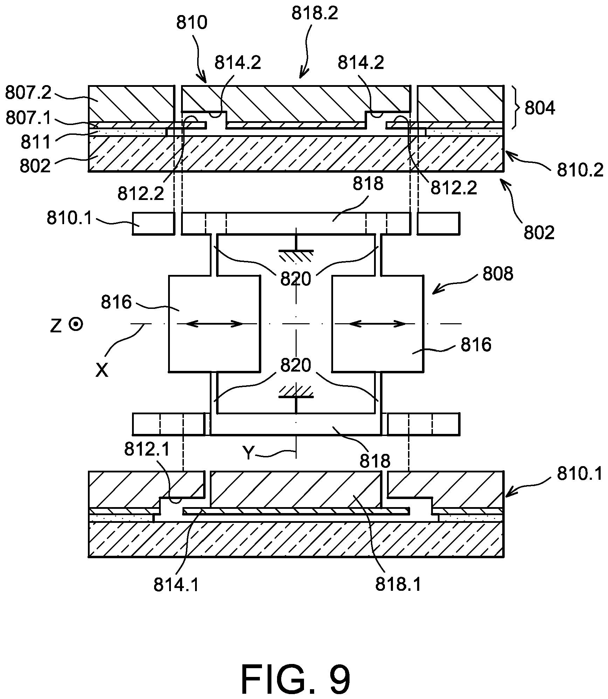

Sur la figure 9, on peut voir un exemple de réalisation d'une structure micromécanique pouvant être utilisée dans un gyroscope Y. Sur la figure 9, les peignes d'excitation et les électrodes de compensation du biais en quadrature ne sont pas représentés.

Le gyroscope comporte une structure active 804 déposée sur un substrat 802. Selon la présente invention, la partie active est formée d'un empilement d'au moins deux couches 807.1, 807.2 reposant sur une couche sacrificielle 811 dont le matériau est gravable de manière sélective par rapport au(x) matériaux(x) de l'empilement.

La structure active comporte une partie mobile 808 et une partie fixe 810, chacune comportant des faces en regard respectivement, ces faces en regard formant des électrodes de détection, de contre-réaction, de trimming...

La détection de la rotation de la partie mobile se fait suivant l'axe Z perpendiculaire au plan de la feuille.

Dans l'exemple représenté, la partie mobile comporte deux masses mobiles 816 disposées l'une à côté de l'autre symétriquement par rapport à l'axe Y, et deux poutres 818.1, 818.2 disposées parallèlement de part et d'autre des deux masses mobiles. Chaque masse mobile est reliée aux deux poutres par un segment de liaison 820. La partie mobile 808 est symétrique par rapport à l'axe Y. Dans l'exemple représenté, les segments de liaison 820 sont perpendiculaires à l'axe des poutres et aux faces des masses mobiles auxquelles ils sont attachés.

La partie fixe 810 est également en deux sous-parties 810.1, 810.2, chacune coopérant avec les deux poutres 818 de la partie mobile.

La sous-partie fixe 810.1 comporte des électrodes 812.1 formées dans la deuxième couche, et la poutre 818.1 comporte des électrodes 814.1 formées dans la première couche, la poutre 818.1 ayant la forme d'un T renversé et la sous-partie fixe 810.1 comportant un logement de forme correspondante.

La sous-partie fixe 810.2 comporte des électrodes 812.2 formées dans la première couche, et la poutre 818.2 comporte des électrodes 814.2 formées dans la deuxième couche, la poutre 818.2 ayant la forme d'un T à l'endroit dont les branches sont en regard de la première couche de l'empilement.

On met en oeuvre une couche sacrificielle 811 dont le matériau est gravable de manière sélective par rapport au(x) matériaux (x) de l'empilement, ce qui permet de simplifier le procédé de réalisation.

Cette structure est également applicable à un actionneur.

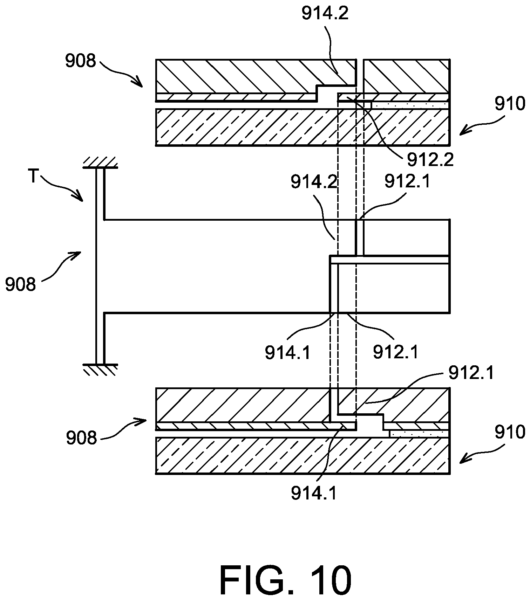

Sur la figure 10, on peut voir un exemple de réalisation d'un système particulièrement intéressant pour réaliser le trimming, de contre-réaction ou de détection différentielle d'un oscillateur ou la détection d'un mouvement hors-plan.

Ce système comporte une partie mobile 908 de forme sensiblement rectangulaire, apte à se déplacer autour d'un axe de torsion T orthogonal à sa direction longitudinale, situé à une première extrémité longitudinale.

La partie mobile comporte au niveau d'une seconde extrémité opposée à celle portant l'axe de torsion T, à la fois une électrode 914.1 formée dans la première couche de l'empilement et une électrode 914.2 formée dans la deuxième couche de l'empilement, les deux électrodes 914.1, 914.2 étant côte à côte. Inversement, la partie fixe 910 comporte une électrode 912.1 formée dans la deuxième couche de l'empilement en regard de l'électrode 914.1 dans la première couche de la partie mobile 908 et une deuxième électrode 912.2 dans la deuxième couche de l'empilement en regard de l'électrode 914.2 formée dans la première couche de l'empilement de l'électrode mobile 908.

Ce système est particulièrement adapté pour réaliser un accéléromètre vertical.

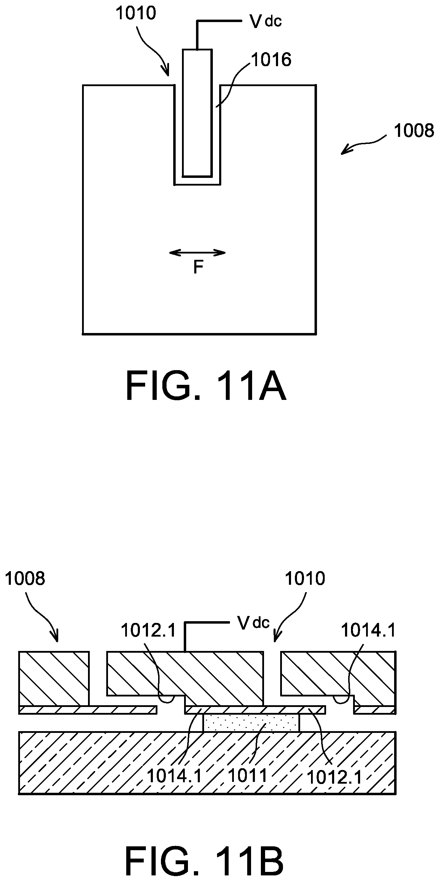

La présente invention permet également de réaliser des électrodes de correction de biais en quadrature pour la correction d'une composante vertical d'un mouvement horizontal, applicable dans un gyroscope X/Y avec une excitation dans le plan. Une vue de détail d'un tel système est visible sur les figures 11A et 11B.

Dans cet exemple, la partie fixe 1010 est reçue dans une encoche 1016 formée dans la partie mobile 1008, de sorte que les bords de la partie fixe 1010 soit en regard des bords de l'encoche. Lors du déplacement de la partie fixe dans la direction de la double flèche F, un bord latéral de l'encoche 1016 se rapproche du bord latéral en regard de la partie fixe et l'autre bord latéral s'éloigne de l'autre bord latéral de la partie fixe.

La partie fixe 1010 comporte une électrode supérieure 1012.1 formée dans la deuxième couche de l'empilement et une électrode inférieure 1012.2 formée dans la première couche de l'empilement opposée par rapport à la zone de fixation au substrat. La partie mobile 1008 a une électrode inférieure 1014.1 formée dans la première couche, et une électrode supérieure 1014.2 formée dans la deuxième couche.

La couche sacrificielle 1011 est interposée entre l'empilement et le substrat.

L'application d'une tension statique sur l'électrode de compensation de biais permet de générer une force selon Z proportionnelle au déplacement Ax qui permet de compenser un biais en quadrature mécanique (amené par exemple par un coefficient de raideur non-diagonal des bras de suspension des masses) en générant un force élastique de rappel selon Z sous la forme Fz = -kxz.x. La tension statique est réglée de telle sorte qu'elle annule la vibration parasite suivant Z. La vibration résultante des masses ne se fait alors que suivant la direction x désirée.

Les capteurs et les actionneurs hors plan peuvent comporter une partie active formée de plus de deux couches, comme la structure représentée sur la figure 6.

Les procédés de réalisation décrits sur les figures 7A à 7G et 8A à 8I s'appliquent entièrement à la réalisation de structures MEMS ou NEMS à déplacement hors plan.

## Revendications

1. Procédé de réalisation d'une structure micromécanique comportant un substrat (2; 802) et un empilement (4; 804) d'au moins une première et une deuxième couche active (4.1, 4.2; 807.1, 807.2) disposé sur le substrat, une partie mobile (8; 808) formée dans l'empilement et une partie fixe (10; 810) par rapport au substrat formée dans l'empilement, la partie mobile comportant des portions des au moins première et deuxième couches dudit empilement et la partie fixe comportant des portions des au moins première et deuxième couches dudit empilement, la partie fixe et la partie mobile comportant une première surface (18.1, 20.1; 812.2, 814.1) et deuxième surface (18.2, 20.2; 812.1, 814.2) en regard sensiblement parallèles à un plan moyen de la structure, ladite première surface (18.1, 20.1; 812.2, 814.1) étant formée dans la première couche (4.1; 807.1) de l'empilement et ladite deuxième surface (18.2, 20.2; 812.1, 814.2) étant formée dans la deuxième couche (4.2; 807.2) de l'empilement,
lesdites première et deuxième surfaces (18.1, 18.2, 20.1, 20.2; 812.1, 812.2, 814.1, 814.2) en regard étant configurées pour former des butées ou des électrodes, dans lequel les butées sont formées par la première surface (20.1; 812.2) de la partie fixe (10; 810) et la deuxième surface (20.2; 814.2) de la partie mobile (8; 808), et/ou par la deuxième surface (18.2; 812.1) de la partie fixe (10; 810) et la première surface (18.1; 814.1) de la partie mobile (8; 808), ou
les électrodes sont formées par la première surface (20.1; 812.2) de la partie fixe (10; 810) et la deuxième surface (20.2; 814.2) de la partie mobile (8; 808), et/ou par la deuxième surface (18.2; 812.1) de la partie fixe (10; 810) et la première surface (18.1; 814.1) de la partie mobile (8; 808),
ledit procédé comportant : à partir d'un empilement d'au moins une première couche sacrificielle (604) et de la première couche active (606), les étapes :
a) de structuration de la première couche active (606) de sorte à révéler la première couche sacrificielle en au moins deux zones,
b) de formation d'une deuxième couche sacrificielle (608) sur la première couche active (606), la deuxième couche sacrificielle recouvrant les dites zones révélant la première couche sacrificielle et traversant la première couche active et étant en contact avec ladite première couche sacrificielle dans lesdites zones,
c) de structuration de ladite deuxième couche sacrificielle de sorte à obtenir des portions de deuxième couche sacrificielle sur la première couche active au niveau des dites zones où la deuxième couche sacrificielle traverse la première couche active,
d) de formation d'une deuxième couche active (610) sur les portions de la deuxième couche sacrificielle structurée et sur la première couche active avec laquelle elle est directement en contact,
le matériau de la deuxième couche sacrificielle pouvant être gravé de manière sélective par rapport à ceux des première et deuxième couches actives,
e) de structuration des première et deuxième couches actives (606, 610) pour atteindre les portions de la deuxième couche sacrificielle structurée (608) et la première couche sacrificielle,
f) d'élimination des portions de la deuxième couche sacrificielle structurée (608) entre les faces en regard des première et deuxième couches actives,
g) d'élimination au moins partielle de la première couche sacrificielle (604) libérant la partie mobile (618).

2. Procédé de réalisation d'une structure micromécanique comportant un substrat (502) et un empilement d'une première (504.1), d'une deuxième (504.2) et d'une troisième (504.3) couche active disposé sur le substrat, une partie mobile (508) formée dans l'empilement et une partie fixe (510) par rapport au substrat (502) formée dans l'empilement, la partie mobile (508) comportant des portions des au moins trois couches (504.1, 504.2, 504.3) dudit empilement et la partie fixe (510) comportant des portions des au moins trois couches (504.1, 504.2, 504.3) dudit empilement, la partie fixe (510) et la partie mobile (508) comportant des première et deuxième surfaces en regard sensiblement parallèles à un plan moyen de la structure, ladite première surface étant formée dans la première couche (504.1) ou la deuxième couche (504.2) de l'empilement et ladite deuxième surface étant formée dans la deuxième couche (504.2) ou la troisième couche (504.1) de l'empilement,
lesdites première et deuxième surfaces en regard étant configurées pour former des butées (516) ou des électrodes, dans lequel les butées (516) sont formées par la première surface de la partie fixe (510) et la deuxième surface de la partie mobile (508), et/ou par la deuxième surface de la partie fixe (510) et la première surface de la partie mobile (508),ou
les électrodes sont formées par la première surface de la partie fixe (510) et la deuxième surface de la partie mobile (508), et/ou par la deuxième surface de la partie fixe (510) et la première surface de la partie mobile (508),
ledit procédé comportant : à partir d'un empilement d'au moins une première couche sacrificielle (704) et de la première couche active (706), les étapes :
a') de structuration de la première couche active (706) de sorte à révéler la première couche sacrificielle (704) en au moins deux zones,
b') de formation d'une deuxième couche sacrificielle (708) sur la première couche active (706), la deuxième couche sacrificielle 708) recouvrant les zones révélant la première couche sacrificielle (704) et traversant la première couche active (706) et étant en contact avec ladite première couche sacrificielle (704),
c') de structuration de ladite deuxième couche sacrificielle (708) de sorte à obtenir au moins une première et une deuxième portion (708', 708'') sur la première couche active (706), au niveau de certaines zones correspondant aux zones où les deux faces sont parallèles et où la deuxième couche sacrificielle (708) traverse la première couche active (706),
d') de formation de la deuxième couche active (710) sur les première et deuxième portions (708', 708'') de la deuxième couche sacrificielle structurée (708) et sur la première couche active (704), la deuxième couche active (710) étant directement en contact avec la première couche active (706),
e') de structuration de la deuxième couche active (710) au moins en certaines zones situées au niveau de la première portion (708') de sorte à révéler ladite première portion (708),
f') de formation d'une troisième couche sacrificielle (712) sur la deuxième couche active (710),
g') de structuration de la troisième couche sacrificielle (712) de sorte à obtenir au moins une portion de ladite troisième couche sacrificielle recouvrant au moins partiellement la zone révélant la première portion (708') de la deuxième couche sacrificielle (708) et traversant la deuxième couche active (710) et étant en contact avec ladite première portion (708') de la deuxième couche sacrificielle (708),
h') de formation de la troisième couche active (715) sur la au moins une portion de la troisième couche sacrificielle (712) structurée et sur la deuxième couche active (710) avec laquelle elle est directement en contact, les matériaux des deuxième (708) et troisième couches (712) sacrificielles pouvant être gravés de manière sélective par rapport à ceux des première (706), deuxième (708) et troisième (715) couches actives,
i') de structuration des trois couches actives (706, 710, 715) pour atteindre les portions des deuxième (708) et troisième (712) couches sacrificielles et la première couche sacrificielle (704),
j') d'élimination des portions des deuxième (708) et troisième (715) couches sacrificielles structurées entre les faces en regard des première (706) et deuxième (708) couches actives et entre les deuxième (710) et troisième (715) couches actives,
k') d'élimination au moins partielle de la première couche sacrificielle (704) libérant la partie mobile.

3. Procédé de réalisation d'une structure micromécanique selon la revendication 2, dans lequel lors de l'étape c'), la première portion (708') de la deuxième couche sacrificielle (708) comporte une surface inférieure à celle de la deuxième portion (708''), la première portion (708') ayant une surface proche de la section de la portion de deuxième couche sacrificielle (708) traversant la première couche active (706) .

4. Procédé de réalisation d'une structure micromécanique selon l'une des revendications 1 à 3, dans lequel le matériau de la deuxième couche et/ou de la troisième couche sacrificielle est un oxyde.

5. Procédé de réalisation d'une structure micromécanique selon l'une des revendications 1 à 4, dans lequel la formation de la deuxième couche active et/ou de la troisième couche active est réalisée par croissance épitaxiale.

6. Procédé de réalisation selon l'une des revendications 1 à 5, dans lequel chacune des couches actives de l'empilement est en silicium ou en SiGe.

7. Procédé de réalisation selon l'une des revendications 1 à 6, dans lequel la première couche sacrificielle (604, 704) est en oxyde de silicium, et fait partie d'un substrat SOI.

8. Structure micromécanique obtenue par le procédé selon l'une des revendications 1 à 7, comportant :
un substrat (2; 802) et un empilement (4; 804) d'au moins une première et une deuxième couches (4.1, 4.2; 807.1, 807.2) disposé sur le substrat (2; 802), une partie mobile (8; 808) formée dans l'empilement (4; 804) et une partie fixe (10; 810) par rapport au substrat (2; 802) formée dans l'empilement (4; 804), la partie mobile (8; 808) comportant des portions des au moins première et deuxième couches (4.1, 4.2; 807.1, 807.2) dudit empilement (4; 804) et la partie fixe (10; 810) comportant des portions des au moins première et deuxième couches (4.1, 4.2; 807.1, 807.2) dudit empilement (4; 804), la partie fixe (10; 810) et la partie mobile (8; 808) comportant une première et une deuxième surface (18.1, 18.2, 20.1, 20.2; 812.1, 812.2, 814.1, 814.2) en regard sensiblement parallèles à un plan moyen de la structure (2; 802), ladite première surface (18.1, 20.1; 812.2, 814.1) étant formée dans la première couche (4.1; 807.1) de l'empilement et ladite deuxième surface (18.2, 20.2; 812.1, 814.2) étant formée dans la deuxième couche (4.2; 807.2) de l'empilement,
lesdites première et deuxième surfaces (18.1, 18.2, 20.1, 20.2; 812.1, 812.2, 814.1, 814.2) en regard étant configurées pour former des butées ou des électrodes, dans lequel les butées sont formées par la première surface (20.1; 812.2) de la partie fixe (10; 810) et la deuxième surface (20.2; 814.2) de la partie mobile (8; 808), et/ou par la deuxième surface (18.2; 812.1) de la partie fixe (10; 810) et la première surface (18.1; 814.1) de la partie mobile (8; 808),
ou les électrodes sont formées par la première surface (20.1; 812.2) de la partie fixe (10; 810) et la deuxième surface (20.2; 814.2) de la partie mobile (8; 808), et/ou par la deuxième surface (18.2; 812.1) de la partie fixe (10; 810) et la première surface (18.1; 814.1) de la partie mobile (8; 808),
et un matériau (11; 811) étant interposé entre la partie fixe (10; 810) et le substrat (2; 802), ledit matériau (11; 811) étant différent de celui ou de ceux des couches (4.1, 4.2; 807.1, 807.2) de l'empilement (4; 804) formant les parties fixe (10; 810) et mobile (8; 808), ledit matériau (11; 811) pouvant être gravé de manière sélective par rapport à celui ou à ceux des couches (4.1, 4.2; 807.1, 807.2) de l'empilement (4; 804).

9. Structure micromécanique selon la revendication 8, dans laquelle l'empilement comporte une premier et une deuxième paires de faces en regard, la face de la première paire appartenant à la partie mobile étant dans un même plan que la face de la deuxième paire appartenant à la partie fixe et la face de la première paire appartenant à la partie fixe étant dans le même plan que la face de la deuxième paire appartenant à la partie mobile.

10. Structure micromécanique selon la revendication 8 ou 9, dans laquelle, en fonctionnement normal, la partie mobile est destinée à se déplacer dans une direction orthogonale au plan moyen de la structure et dans laquelle les faces en regard des parties fixe et mobile forment des électrodes, la partie fixe et la partie mobile étant à des potentiels différents.

11. Structure micromécanique selon l'une des revendications 8 ou 9, dans laquelle, en fonctionnement normal, la partie mobile est destinée à se déplacer dans le plan moyen de la structure et dans laquelle les faces en regard des parties fixe et mobile forment des moyens de butée (16, 116, 216, 316, 416, 516) pour limiter le déplacement de la partie mobile (8, 108, 208, 308, 408, 508) dans une direction sensiblement perpendiculaire à l'empilement (4, 104, 204, 304, 404, 504).

12. Structure micromécanique selon la revendication 11, dans laquelle l'empilement (4, 104, 204, 304, 404, 504) comporte au moins une première couche du côté du substrat et une deuxième couche sur la première couche à l'opposé du substrat (2, 102, 202, 302, 402, 502), et dans laquelle les moyens de butée 16, 116, 216, 316, 416, 516) comportent au moins une butée inférieure pour limiter le déplacement de la partie mobile vers le substrat et/ou au moins une butée supérieure pour limiter le déplacement de la partie mobile (8, 108, 208, 308, 408, 508) à l'opposé du substrat, la butée inférieure étant définie dans la première couche de la partie fixe (10, 110, 210, 310, 410, 510) et dans la deuxième couche de la partie mobile (8, 108, 208, 308, 408, 508) et la butée supérieure étant définie dans la deuxième couche de la partie fixe (10, 110, 210, 310, 410, 510) et dans la première couche de la partie mobile (8, 108, 208, 308, 408, 508).

13. Structure micromécanique selon la revendication 11 ou 12, dans laquelle la butée inférieure comporte une surface dans la première couche de la partie fixe (10, 110, 210, 310, 410, 510) et une surface dans la deuxième couche de la partie mobile (8, 108, 208, 308, 408, 508), les deux surfaces étant en regard et la butée supérieure comporte une surface dans la deuxième couche de la partie fixe (10, 110, 210, 310, 410, 510) et une surface dans la première couche de la partie mobile (8, 108, 208, 308, 408, 508), les deux surfaces étant en regard.

14. Structure micromécanique selon l'une quelconque des revendications 11 à 13, dans laquelle l'empilement (504) comporte au moins une première (504.1), une deuxième (504.2) et une troisième (504.3) couche, et dans laquelle les moyens de butée (516) comportent au moins une butée inférieure (520) pour limiter le déplacement de la partie mobile (508) vers le substrat (502) et/ou au moins une butée supérieure (518) pour limiter le déplacement de la partie mobile (508) à l'opposé du substrat (502), la butée inférieure (520) étant définie dans la première couche (504.1) de la partie fixe (510) et dans la deuxième couche (504.2) de la partie mobile (508) et la butée supérieure (518) étant définie dans la deuxième couche (504.2) de la partie mobile (508) et dans la troisième couche (504.3) de la partie fixe (510).

15. Structure micromécanique selon l'une quelconque des revendications 11 à 14, dans laquelle la partie fixe (110) comporte au moins trois doigts (132.1, 132.2, 132.3), et la partie mobile (108) comporte au moins trois doigts (128.1, 128.2, 128.), les doigts (132.1, 132.2, 132.3) de la partie fixe (110) et ceux (128.1, 128.2, 128.3) de la partie mobile (108) étant interdigités, dans laquelle la butée supérieure (118) est formée par un (128.1) des doigts de la partie mobile (108) reçu entre deux doigts (132.1, 132.2) de la partie fixe (110), ledit doigt (128.1) comportant deux éléments latéraux (134) portant chacune une surface de la butée supérieure, chaque élément latéral (134) étant reçu dans un logement de forme complémentaire formé par les deux doigts (132.1, 132.2) de la partie fixe (110) de part et d'autre dudit doigt (128.1) de la partie mobile (108), le fond de ces logements formant la surface en regard de la butée supérieure (118), et dans laquelle la butée inférieure (120) est formée par un des doigts (132.3) de la partie fixe (110) reçu entre deux doigts (128.2, 128.3) de la partie mobile (108), ledit doigt (132.3) comportant deux éléments latéraux (136) portant chacune une surface, chaque élément latéral (136) étant reçu dans un logement de forme complémentaire formé par les deux doigts (128.2, 128.3) de la partie mobile (108) de part et d'autre dudit doigt (132.3) de la partie fixe (110), le fond de ces logements formant la surface en regard.

16. Structure micromécanique selon l'une quelconque des revendications 11 à 15, dans laquelle la partie fixe (210, 310) comporte une face parallèle à une face de la partie mobile (208, 308) et en regard de ladite face, lesdites faces étant sensiblement orthogonales au plan de la structure, chaque face comportant au moins un doigt (238, 244, 338, 344) en saillie, le doigt (238, 338) de la partie mobile (208, 308) étant reçu dans un logement (240, 340) de la partie fixe (210, 310) de forme correspondante et le doigt (244, 344) de la partie fixe (210, 310) étant reçu dans un logement (246, 346) de la partie mobile (208, 308) de forme correspondante.

17. Structure micromécanique selon l'une quelconque des revendications 11 à 16, comportant des butées pour limiter le déplacement de la partie mobile dans le plan, dites butées latérales, et/ou dans laquelle les logements forment également lesdites butées latérales.

18. Structure micromécanique selon la revendication 11, dans laquelle la partie mobile (808) comporte au moins une masse mobile et deux poutres (818.1, 818.2) de part et d'autre de la masse mobile auxquelles la masse mobile est reliée par des segments, les poutre portant les électrodes, chacune des poutres coopérant avec une sous-partie de la partie fixe (810) portant les électrodes en regard.

19. Structure micromécanique selon la revendication 11, dans laquelle la partie mobile (908) comporte une première et une deuxième électrode disposées côte à côte et la partie fixe (910) comporte une première et une deuxième électrode disposées côte à côte, chacune en regard d'une électrode de la partie mobile (908), la première électrode de la partie mobile (908) étant réalisée dans la première couche et la première électrode de la partie fixe étant réalisée dans la deuxième couche en regard de la première électrode de la partie mobile (908), et la deuxième électrode de la partie mobile (908) étant réalisée dans la deuxième couche et la deuxième électrode de la partie fixe (910) étant réalisée dans la première couche en regard de la deuxième électrode de la partie mobile (908).

20. Structure micromécanique selon la revendication 19, dans laquelle la partie mobile (908) présente une forme allongée dont une première extrémité longitudinale est montée sur un axe de torsion orthogonal à l'axe de la partie mobile (908) et dont une deuxième extrémité porte les électrodes.

21. Structure micromécanique selon la revendication 11, dans laquelle, en considérant le plan moyen de la structure, la partie mobile (1008) comporte un logement formé d'une encoche de forme rectangulaire réalisée dans un bord de la partie mobile (1008), la partie fixe (1010) étant reçue dans cette encoche et ayant une forme correspondante à celle de l'encoche, ses bords latéraux faisant face aux bords latéraux de la partie mobile (1008), les électrodes étant portées par les bords latéraux de l'encoche et de l'électrode mobile (1008), la partie mobile (1008) étant destinée à se déplacer dans une direction sensiblement orthogonale aux bords latéraux.

22. Structure micromécanique selon l'une quelconque des revendications 11, 18 à 21, dans laquelle les électrodes sont portées par des doigts interdigités réalisés dans la première ou la deuxième couche.

23. Capteur comportant au moins une structure micromécanique selon l'une des revendications 8 à 22.

## Patentansprüche

1. Verfahren zum Herstellen einer mikromechanischen Struktur, umfassend ein Substrat (2; 802) und einen Stapel (4; 804) von wenigstens einer ersten und einer zweiten aktiven Schicht (4.1, 4.2; 807.1, 807.2), welcher an dem Substrat angeordnet ist, einen beweglichen Teil (8; 808), welcher in dem Stapel gebildet ist, und einen bezüglich dem Substrat festen Teil (10; 810), welcher in dem Stapel gebildet ist, wobei der bewegliche Teil Abschnitte der wenigstens ersten und zweiten Schichten des Stapels umfasst und der feste Teil Abschnitte der wenigstens ersten und zweiten Schichten des Stapels umfasst, wobei der feste Teil und der bewegliche Teil eine erste Fläche (18.1, 20.1; 812.2, 814.1) und eine zweite Fläche (18.2, 20.2; 812.1, 814.2) einander gegenüberliegend im Wesentlichen parallel zu einer Mittelebene der Struktur umfassen, wobei die erste Fläche (18.1, 20.1; 812.2, 814.1) in der ersten Schicht (4.1; 807.1) des Stapels gebildet ist und die zweite Fläche (18.2, 20.2; 812.1, 814.2) in der zweiten Schicht (4.2; 807.2) des Stapels gebildet ist,
wobei die einander gegenüberliegenden ersten und zweiten Flächen (18.1, 18.2, 20.1, 20.2; 812.1, 812.2, 814.2, 814.2) dazu eingerichtet sind, Anlagen oder Elektroden zu bilden, wobei die Anlagen durch die erste Fläche (20.1; 812.2) des festen Teils (10; 810) und die zweite Fläche (20.2; 814.2) des beweglichen Teils (8; 808) und/oder durch die zweite Fläche (18.2; 812.1) des festen Teils (10; 810) und die erste Fläche (18.1; 814.1) des beweglichen Teils (8; 808) gebildet sind, oder
die Elektroden durch die erste Fläche (20.1; 812.2) des festen Teils (10; 810) und die zweite Fläche (20.2; 814.2) des beweglichen Teils (8; 808) und/oder durch die zweite Fläche (18.2; 812.1) des festen Teils (10; 810) und die erste Fläche (18.1; 814.1) des beweglichen Teils (8; 808) gebildet sind,
wobei das Verfahren umfasst: ausgehend von einem Stapel von wenigstens einer ersten Opferschicht (604) und der ersten aktiven Schicht (606) die Schritte:
a) eines Strukturierens der ersten aktiven Schicht (606) derart, dass die erste Opferschicht in wenigstens zwei Zonen freigelegt wird,
b) eines Bildens einer zweiten Opferschicht (608) an der ersten aktiven Schicht (606), wobei die zweite Opferschicht die Zonen bedeckt, welche die erste Opferschicht freilegen und die erste aktive Schicht durchqueren, und in Kontakt mit der ersten Opferschicht in den Zonen ist,
c) eines Strukturierens der zweiten Opferschicht derart, dass Abschnitte der zweiten Opferschicht an der ersten aktiven Schicht auf dem Niveau der Zonen erhalten werden, wo die zweite Opferschicht die erste aktive Schicht durchquert,
d) eines Bildens einer zweiten aktiven Schicht (610) an den Abschnitten der strukturierten zweiten Opferschicht und an der ersten aktiven Schicht, mit der sie direkt in Kontakt ist,
wobei das Material der zweiten Opferschicht bezüglich denjenigen der ersten und zweiten aktiven Schichten in selektiver Weise geätzt werden kann,
e) eines Strukturierens der ersten und zweiten aktiven Schichten (606, 610), um die Abschnitte der strukturierten zweiten Opferschicht (608) und der ersten Opferschicht zu erreichen,
f) eines Entfernens der Abschnitte der strukturierten zweiten Opferschicht (608) zwischen den einander gegenüberliegenden Flächen der ersten und zweiten aktiven Schichten,
g) eines wenigstens teilweisen Entfernens der ersten Opferschicht (604), wodurch der bewegliche Teil (618) freigelegt wird.

2. Verfahren zum Herstellen einer mikromechanischen Struktur, umfassend ein Substrat (502) und einen Stapel von einer ersten (504.1), einer zweiten (504.2) und einer dritten (504.3) aktiven Schicht, welcher an dem Substrat angeordneten ist, einen an dem Stapel gebildeten beweglichen Teil (508) und einen an dem Stapel gebildeten bezüglich dem Substrat (502) festen Teil (510), wobei der bewegliche Teil (508) Abschnitte der wenigstens drei Schichten (504.1, 504.2, 504.2) des Stapels umfasst und der feste Teil (510) Abschnitte der wenigstens drei Schichten (504.1, 504.2, 504.3) des Stapels umfasst, wobei der feste Teil (510) und der bewegliche Teil (508) einander gegenüberliegende erste und zweite Flächen im Wesentlichen parallel zu einer Mittelebene der Struktur umfassen, wobei die erste Fläche in der ersten Schicht (504.1) oder der zweiten Schicht (504.2) des Stapels gebildet ist und die zweite Fläche in der zweiten Schicht (504.2) oder der dritten Schicht (504.1) des Stapels gebildet ist, wobei die einander gegenüberliegenden ersten und zweiten Flächen dazu eingerichtet sind, Anlagen (516) oder Elektroden zu bilden, wobei die Anlagen (516) durch die erste Fläche des festen Teils (510) und die zweite Fläche des beweglichen Teils (508) gebildet sind, und/oder durch die zweite Fläche des festen Teils (510) und die erste Fläche des beweglichen Teils (508), oder die Elektroden durch die erste Fläche des festen Teils (510) und die zweite Fläche des beweglichen Teils (508) und/oder durch die zweite Fläche des festen Teils (510) und die erste Fläche des beweglichen Teils (508) gebildet sind, wobei das Verfahren umfasst: ausgehend von einem Stapel von wenigstens einer ersten Opferschicht (704) und der ersten aktiven Schicht (706) die Schritte:
a') eines Strukturierens der ersten aktiven Schicht (706) derart, dass die erste Opferschicht (704) in wenigstens zwei Zonen freigelegt wird,
b') eines Bildens einer zweiten Opferschicht (708) an der ersten aktiven Schicht (706), wobei die zweite Opferschicht (708) die Zonen bedeckt, welche die erste Opferschicht (704) freilegen, und die erste aktive Schicht (706) durchqueren und in Kontakt mit der ersten Opferschicht (704) sind,
c') eines Strukturierens der zweiten Opferschicht (708) derart, dass wenigstens ein erster und ein zweiter Abschnitt (708', 708") an der ersten aktiven Schicht (706) auf dem Niveau von bestimmten Zonen erhalten werden, welche den Zonen entsprechen, wo die beiden Flächen parallel sind und wo die zweite Opferschicht (708) die erste aktive Schicht (706) durchquert,
d') eines Bildens der zweiten aktiven Schicht (710) an den ersten und zweiten Abschnitten (708', 708") der strukturierten zweiten Opferschicht (708) und an der ersten aktiven Schicht (704), wobei die zweite aktive Schicht (710) direkt in Kontakt mit der ersten aktiven Schicht (706) ist,
e') eines Strukturierens der zweiten aktiven Schicht (710) wenigstens in bestimmten Zonen, welche auf dem Niveau des ersten Abschnitts (708') platziert sind, derart, dass der erste Abschnitt (708) freigelegt wird,
f') eines Bildens einer dritten Opferschicht (712) an der zweiten aktiven Schicht (710),
g') eines Strukturierens der dritten Opferschicht (712) derart, dass wenigstens ein Abschnitt der dritten Opferschicht erhalten wird, welcher die Zone wenigstens teilweise bedeckt, welche den ersten Abschnitt (708') der zweiten Opferschicht (708) freilegt, und die zweite aktive Schicht (710) durchquert und in Kontakt mit dem ersten Abschnitt (708') der zweiten Opferschicht (708) ist,
h') eines Bildens der dritten aktiven Schicht (715) an dem wenigstens einen Teil der strukturierten dritten Opferschicht (712) und an der zweiten aktiven Schicht (710), mit welcher sie direkt in Kontakt ist, wobei die Materialien der zweiten und dritten Opferschichten (712) bezüglich derjenigen der ersten (706), zweiten (708) und dritten (715) aktiven Schichten in selektiver Weise geätzt werden können,
i') eines Strukturierens der drei aktiven Schichten (706, 710, 715), um die Abschnitte der zweiten (708) und dritten (712) Opferschichten und die erste Opferschicht (704) zu erreichen,
j') eines Entfernens der Abschnitte der strukturierten zweiten (708) und dritten (715) Opferschichten zwischen den einander gegenüberliegenden Flächen der ersten (706) und zweiten (708) aktiven Schichten und zwischen den zweiten (710) und dritten (715) aktiven Schichten,
k') eines wenigstens teilweisen Entfernens der ersten Opferschicht (704) wodurch der bewegliche Abschnitt freigelegt wird.

3. Verfahren zum Herstellen einer mikromechanischen Struktur nach Anspruch 2, wobei während des Schritts c') der erste Abschnitt (708') der zweiten Opferschicht (708) eine Fläche unterhalb derjenigen des zweiten Abschnitts (708") umfasst, wobei der erste Abschnitt (708') eine Fläche nahe dem Abschnitt des Teils der zweiten Opferschicht (708) aufweist, welcher die erste aktive Schicht (706) durchquert.

4. Verfahren zum Herstellen einer mikromechanischen Struktur nach einem der Ansprüche 1 bis 3, wobei das Material der zweiten und/oder der dritten Opferschicht ein Oxid ist.

5. Verfahren zum Herstellen einer mikromechanischen Struktur nach einem der Ansprüche 1 bis 4, wobei das Bilden der zweiten aktiven Schicht und/oder der dritten aktiven Schicht durch epitaktisches Wachsen durchgeführt wird.

6. Verfahren zum Herstellen nach einem der Ansprüche 1 bis 5, wobei jede der aktiven Schichten des Stapels aus Silizium oder aus SiGe ist.

7. Verfahren zum Herstellen nach einem der Ansprüche 1 bis 6, wobei die erste Opferschicht (604, 704) aus Siliziumoxid ist und einen Teil eines SOI-Substrats bildet.

8. Mikromechanische Struktur, welche durch das Verfahren nach einem der Ansprüche 1 bis 7 erhalten wird, umfassend:
ein Substrat (2; 802) und einen Stapel (4; 804) aus wenigstens einer ersten und einer zweiten Schicht (4.1, 4.2; 807.1, 807.2), welcher an dem Substrat (2; 802) angeordnet ist, einen beweglichen Teil (8; 808), welcher in dem Stapel (4; 804) gebildet ist, und einen bezüglich des Substrats (2; 802) festen Teil (10; 810), welcher in dem Stapel (4; 804) gebildet ist, wobei der bewegliche Teil (8; 808) Abschnitte der wenigstens ersten und zweiten Schichten (4.1, 4.2; 807.1, 807.2) des Stapels (4; 804) umfasst und der feste Teil (10; 810) Abschnitte der wenigstens ersten und zweiten Schichten (4.1, 4.2; 807.1, 807.2) des Stapels (4; 804) umfasst, wobei der feste Teil (10; 810) und der bewegliche Teil (8; 808) eine erste und eine zweite Fläche (18.1, 18.2, 20.1, 20.2; 812.1, 812.2, 814.1, 814.2) einander gegenüberliegend im Wesentlichen parallel zu einer Mittelebene der Struktur (2; 802) umfassen, wobei die erste Fläche (18.1, 20.1; 812.2, 814.1) in der ersten Schicht (4.1; 807.1) des Stapels gebildet sind und die zweite Fläche (18.2, 20.2; 812.1 814.2) in der zweiten Schicht (4.2; 807.2) des Stapels gebildet sind,
wobei die einander gegenüberliegenden ersten und zweiten Flächen (18.1, 18.2, 20.1, 20.2; 812.1, 812.2, 814.1, 814.2) dazu eingerichtet sind, Anlagen oder Elektroden zu bilden, wobei die Anlagen durch die erste Fläche (20.1; 812.2) des festen Teils (10; 810) und die zweite Fläche (20.2; 814.2) des beweglichen Teils (8; 808) gebildet sind und/oder durch die zweite Fläche (18.2; 812.1) des festen Teils (10; 810) und die erste Fläche (18.1; 814.1) des beweglichen Teils (8; 808),
oder die Elektroden durch die erste Fläche (20.1; 812.2) des festen Teils (10; 810) und die zweite Fläche (20.2; 814.2) des beweglichen Abschnitts (8; 808) und/oder durch die zweite Fläche (18.2; 812.1) des festen Teils (10; 810) und die erste Fläche (18.1; 814.1) des beweglichen Teils (8; 808) gebildet sind, und wobei ein Material (11; 811) zwischen den festen Teil (10; 810) und das Substrat (2; 802) eingefügt ist, wobei das Material (11; 811) von demjenigen oder denjenigen der Schichten (4.1, 4.2; 807.1, 807.2) des Stapels (4; 804) verschieden ist, welche die festen (10; 810) und beweglichen (8; 808) Teile bilden, wobei das Material (11; 811) bezüglich demjenigen oder derjenigen der Schichten (4.1, 4.2; 807.1, 807.2) des Stapels (4; 804) in selektiver Weise geätzt werden kann.

9. Mikromechanische Struktur nach Anspruch 8, wobei der Stapel erste und zweite Paars von einander gegenüberliegenden Flächen umfasst, wobei die Fläche des ersten Paars, welche zu dem beweglichen Teil gehört, in derselben Ebene liegt wie die Fläche des zweiten Paars, welche zu dem festen Teil gehört, und wobei die Fläche des ersten Paars, welche zu dem festen Teil gehört, in derselben Ebene liegt wie die Fläche des zweiten Paars, welche zu dem beweglichen Teil gehört.

10. Mikromechanische Struktur nach Anspruch 8 oder 9, wobei im normalen Betrieb der bewegliche Teil dazu vorgesehen ist, sich in einer Richtung orthogonal zu der Mittelebene der Struktur zu verlagern, und wobei die einander gegenüberliegenden Flächen der festen und beweglichen Teile Elektroden bilden, wobei der feste Teil und der bewegliche Teil auf unterschiedlichen Potentialen liegen.

11. Mikromechanische Struktur nach einem der Ansprüche 8 oder 9, wobei im normalen Betrieb der bewegliche Teil dazu vorgesehen ist, sich in der Mittelebene der Struktur zu verlagern, und wobei die einander gegenüberliegenden Flächen der festen und beweglichen Teile Anlagemittel (16, 116, 216, 316, 416, 516) bilden, um die Verlagerung des beweglichen Teils (8, 108, 208, 408, 508) in einer Richtung im Wesentlichen senkrecht zu dem Stapel (4, 104, 204, 304, 404, 504) zu begrenzen.

12. Mikromechanische Struktur nach Anspruch 11, wobei der Stapel (4, 104, 204, 304, 404, 504) wenigstens eine erste Schicht neben dem Substrat und eine zweite Schicht an der ersten Sicht gegenüber dem Substrat (2, 102, 202, 302, 402, 502) umfasst, und wobei die Anlagemittel (16, 116, 216, 316, 416, 516) wenigstens eine untere Anlage zum Begrenzen der Verlagerung des beweglichen Teils in Richtung des Substrats und/oder wenigstens eine obere Anlage zum Begrenzen der Verlagerung des beweglichen Teils (8, 108, 208, 308, 408, 508) gegenüber dem Substrat umfassen, wobei die untere Anlage in der ersten Schicht des festen Teils (10, 110, 210, 310, 410, 510) und in der zweiten Schicht des beweglichen Teils (8, 108, 208, 308, 408, 508) definiert ist, und die obere Anlage in der zweiten Schicht des festen Teils (10, 110, 210, 310, 410, 510) und in der ersten Schicht des beweglichen Teils (8, 108, 208, 308, 408, 508) definiert ist.

13. Mikromechanische Struktur nach Anspruch 11 oder 12, wobei die untere Anlage eine Fläche in der ersten Schicht des festen Teils (10, 110, 210, 310, 410, 510) und eine Fläche in der zweiten Schicht des beweglichen Teils (8, 108, 208, 308, 408, 508) umfasst, wobei die beiden Flächen einander gegenüberliegen und die obere Anlage eine Fläche in der zweiten Schicht des festen Teils (10, 110, 210, 310, 410, 510) und eine Fläche in der ersten Schicht des beweglichen Teils (8, 108, 208, 308, 408, 508) umfasst, wobei die beiden Flächen einander gegenüberliegen.

14. Mikromechanische Struktur nach einem der Ansprüche 11 bis 13, wobei der Stapel (504) wenigstens eine erste (504.1), eine zweite (504.2) und eine dritte (504.3) Schicht umfasst, und wobei die Anlagemittel (516) wenigstens eine untere Anlage (520) zum Begrenzen der Verlagerung des beweglichen Teils (508) in Richtung des Substrats (502) und/oder wenigstens eine obere Anlage (518) zum Begrenzen der Verlagerung des beweglichen Teils (508) entgegen dem Substrat (502) umfassen, wobei die untere Anlage (520) in der ersten Schicht (504.1) des festen Teils (510) und in der zweiten Schicht (504.2) des bewegliche Teils (508) der oberen Anlage (518) definiert ist, und wobei die obere Anlage (518) in der zweiten Schicht (504.2) des beweglichen Teils (508) und in der dritten Schicht (504.3) des festen Teils (510) definiert ist.

15. Mikromechanische Struktur nach einem der Ansprüche 11 bis 14, wobei der feste Teil (110) wenigstens drei Finger (132.1, 132.2, 132.3) umfasst und der bewegliche Teil (108) wenigstens drei Finger (128.1, 128.2, 128.) umfasst, wobei die Finger (132.1, 132.2, 132.3) des festen Abschnitts (110) und diejenigen (128.1, 128.2, 128.3) des beweglichen Abschnitts (108) verschränkt sind, wobei die obere Anlage (118) durch einen (128.1) der Finger des beweglichen Teils (108) gebildet ist, welche zwischen zwei Fingern (132.1, 132.2) des festen Teils (110) aufgenommen ist, wobei der Finger (128.1) zwei laterale Elemente (134) umfasst, welche jeweils eine Fläche der oberen Anlage tragen, wobei jedes laterale Element (134) in einer Ausnehmung mit komplementärer Form aufgenommen ist, welche durch die beiden Finger (132.1, 132.2) des festen Teils (110) beiderseits des Fingers (128.1) des beweglichen Teils (108) gebildet ist, wobei der Boden dieser Ausnehmungen die Fläche gegenüber der oberen Anlage (118) bildet, und wobei die untere Anlage (120) durch einen der Finger (132.2) des festen Teils (110) gebildet ist, welcher zwischen zwei Fingern (128.2, 128.3) des beweglichen Teils (108) aufgenommen ist, wobei der Finger (132.3) zwei laterale Elemente (136) umfasst, welche jeweils eine Fläche tragen, wobei jedes laterale Element (136) in einer Ausnehmung mit komplementärer Form aufgenommen ist, welche durch die beiden Finger (128.2, 128.3) des beweglichen Teils (108) beiderseits des Fingers (123.3) des festen Teils (110) gebildet ist, wobei der Boden der Ausnehmungen die gegenüberliegende Fläche bildet.

16. Mikromechanische Struktur nach einem der Ansprüche 11 bis 15, wobei der feste Teil (210, 310) eine Fläche parallel zu einer Fläche des beweglichen Teils (208, 308) und gegenüberliegend zu der Fläche umfasst, wobei die Flächen im Wesentlichen orthogonal zu der Ebene der Struktur sind, wobei jede Fläche wenigstens einen vorstehenden Finger (238, 244, 338, 344) umfasst, wobei der Finger (238, 338) des beweglichen Teils (208, 308) in einer Ausnehmung (240, 340) des festen Teils (210, 310) mit korrespondierender Form aufgenommen ist, und der Finger (244, 344) des festen Teils (210, 310) in einer Ausnehmung (246, 346) des beweglichen Teils (208, 308) mit korrespondierender Form aufgenommen ist.

17. Mikromechanische Struktur nach einem der Ansprüche 11 bis 16, umfassend Anlagen zum Begrenzen der Verlagerung des mobilen Teils in der Ebene, genannt laterale Anlagen, und/oder wobei die Ausnehmungen ebenfalls die lateralen Anlagen bilden.

18. Mikromechanische Struktur nach Anspruch 11, wobei der bewegliche Teil (808) wenigstens eine bewegliche Masse und zwei Träger (818.1, 818.2) beiderseits der beweglichen Masse umfasst, an welchen die bewegliche Masse durch Segmente befestigt ist, wobei die Träger Elektroden tragen, wobei jeder der Träger mit einem Unterteil des festen Teils (810) zusammenwirkt, welcher die Elektroden einander gegenüberliegend trägt.

19. Mikromechanische Struktur nach Anspruch 11, wobei der bewegliche Teil (908) eine erste und eine zweite Elektrode umfasst, welche nebeneinander angeordnet sind, und wobei der feste Teil (910) eine erste und eine zweite Elektrode umfasst, welche nebeneinander angeordnet sind, jede einer Elektrode des beweglichen Teils (908) gegenüberliegend, wobei die erste Elektrode des beweglichen Teils (908) in der ersten Schicht gebildet ist und die erste Elektrode des festen Teils in der zweiten Schicht gegenüber der ersten Elektrode des beweglichen Teils (908) gebildet ist, und wobei die zweite Elektrode des ersten Teils (908) in der zweiten Schicht gebildet ist und die zweite Elektrode des festen Teils (910) in der ersten Schicht der zweiten Elektrode des beweglichen Teils (908) gegenüberliegend gebildet ist.

20. Mikromechanische Struktur nach Anspruch 19, wobei der bewegliche Teil (908) eine längliche Form aufweist, deren erstes longitudinales Ende an einer Spannungsachse orthogonal zu der Achse des beweglichen Teils (908) montiert ist, und deren zweites Ende die Elektroden trägt.

21. Mikromechanische Struktur nach Anspruch 11, wobei bei Betrachtung der Mittelebene der Struktur der bewegliche Teil (1008) eine Ausnehmung umfasst, welche durch eine Kerbe von rechteckiger Form gebildet ist, welche an einem Rand des beweglichen Teils (1008) gebildet ist, wobei der feste Teil (1010) in dieser Kerbe aufgenommen ist und eine Form aufweist, welche derjenigen der Kerbe entspricht, wobei seine lateralen Ränder den lateralen Rändern des beweglichen Teils (1008) gegenüberstehen, wobei die Elektroden durch die lateralen Ränder der Kerbe und der beweglichen Elektrode (1008) getragen sind, wobei der bewegliche Teil (1008) dazu vorgesehen ist, sich in einer Richtung im Wesentlichen senkrecht zu den lateralen Rändern zu verlagern.

22. Mikromechanische Struktur nach einem der Ansprüche 11, 18 bis 21, wobei die Elektroden von den verschränkten Fingern getragen sind, welche in der ersten oder der zweiten Schicht gebildet sind.

23. Sensor, umfassend wenigstens eine mikromechanische Struktur nach einem der Ansprüche 8 bis 22.

## Claims

1. A process for producing a micromechanical structure comprising a substrate (8; 802) and a stack (4; 804) of at least one first and one second active layer (4.1, 4.2; 807.1, 807.2) arranged on the substrate, a mobile part (8; 808) formed in the stack and a fixed part (10; 810) relative to the substrate formed in the stack, the mobile part comprising portions of said at least first and second layers of said stack and the fixed part comprising portions of said at least first and second layers of said stack, the fixed part and the mobile part comprising a first surface (18.1, 20.1: 812.2, 814.1) and a second surface (18.2, 20.2; 812.1, 814.2) facing each other substantially parallel to a medium plane of the structure,
said first surface (18.1, 20.1; 812.2, 814.1) being formed in the first layer (4.1; 807.1) of the stack and said second surface (18.2, 20.2; 812.1, 814.2) being formed in the second layer (4.2; 807.2) of the stack,
said first and second layer (18.1, 18.2, 20.1, 20.2; 812.1, 812.2, 814.1, 814.2) facing each other being configured to form stops or electrodes, in which said stops are formed by the first surface (20.1; 812.2) of the fixed part (10; 810) and the second surface (20.2; 814.2) of the mobile part (8; 808), and/or by the second surface (18.2; 812.1) of the fixed part (10; 810) and the first surface (18.1; 814.1) of the mobile part (8; 808),or
in which said electrode are formed by the first surface (20.1; 812.2) of the fixed part (10; 810) and the second surface (20.2; 814.2) of the mobile part (8; 808), and/or but the second surface (18.2; 812.1) of the fixed part (10; 810) and the first surface (18.1; 814.1) of the mobile part (8; 808),
said process comprising: from a stack of at least one first sacrificial layer (604) and of the first active layer (606):
a)structuring the first active layer (606) so as to reveal the first sacrificial layer in at least two zones,
b) forming a second sacrificial layer (608) on the first active layer (606), the second sacrificial layer covering said zones revealing the first sacrificial layer and passing through the first active layer and being in contact with said first sacrificial layer in said zones,
c) structuring said second sacrificial layer so as to obtain portions of a second sacrificial layer on the first active layer at the level of said zones where the second sacrificial layer passes through the first active layer,
d)forming a second active layer (610) on the portions of the second structured sacrificial layer and on the first active layer with which it is directly in contact,
the material of the second sacrificial layer able to be etched selectively relative to those of the first and second active layers.
e)structuring first and second active layers (606, 610) to attain the portions of the second structured sacrificial layer (608) and the first sacrificial layer,
f)eliminating the portions of the second structured sacrificial layer (608) between the faces facing each other of the first and second active layers,
g)at least partially eliminating the first sacrificial layer (604) releasing the mobile part (618).

2. The process for producing a micromechanical structure comprising a substrate (502) and a stack of a first (504.1), of a second (504.2) and of a third (504.3) active layer arranged on the substrate, a mobile part (508) formed in the stack and a fixed part (510) relative to the substrate (502) formed in the stack, the mobile part (508) comprising portions of said at least three layers (504.1, 504.2, 504.3) of said stack and the fixed part (510) comprising portions of said at least three layers (504.1, 504.2, 504.3) of said stack, the fixed part (510) and the mobile part (508) comprising first and second faces facing each other substantially parallel to a medium plane of the structure, said first surface being formed in the first layer (504.1) of the stack and said second surface being formed in the second layer (504.2) or the third layer (504.3) of the stack,
said first and second layer facing each other being configured to form stops (516) or electrodes, in which said stops (516) are formed by the first surface of the fixed part (510) and the second surface of the mobile part (508), and/or by the second surface of the fixed part (510) and the first surface of the mobile part (508), or
said electrodes are formed by the first surface of the fixed part (510) and the second surface of the mobile part (508), and/or by the second surface of the fixed part (510) and the first surface of the mobile part (508),
said process comprising: from a stack of at least one first sacrificial layer (704) and of the first active layer (706),:
a') structuring the first active layer (706) so as to reveal the first sacrificial layer (704) in at least two zones,
b') forming a second sacrificial layer (708) on the first active layer (706), the second sacrificial layer (708) covering the zones revealing the first sacrificial layer (704) and passing through the first active layer (706) and being in contact with said first sacrificial layer (704),
c') structuring said second sacrificial layer (708) so as to obtain at least one first and a second portion (708', 708'') on the first active layer (706), at the level of some zones corresponding to the zones where the two faces are parallel and where the second sacrificial layer (708) passes through the first active layer (706),
d') formatting the second active layer (710) on the first and second portions (708', 708'') of the second structured sacrificial layer (708) and on the first active layer (704), the second active layer (710) being directly in contact with the first active layer (706),
e') structuring the second active layer (710) at least in some zones located at the level of the first portion (708') so as to reveal said first portion (708),
f') forming a third sacrificial layer (710) on the second active layer (712),
g') structuring the third sacrificial layer (712) so as to obtain at least one portion of said third sacrificial layer at least partially covering the zone revealing the first portion (708') of the second sacrificial layer (708) and passing through the second active layer (710) and being in contact with said first portion (708') of the second sacrificial layer (708),
h') forming the third active layer (715) on the at least one portion of the third structured sacrificial layer (712) and on the second active layer (710) with which it is directly in contact, the materials of the second (708) and third sacrificial layers (712) able to be etched selectively relative to those of the first (706), second (708) and third (715) active layers,
i') structuring three active layers (706, 710, 715) to attain the portions of the second (708) and third (712) sacrificial layers and the first sacrificial layer (704),
j') eliminating the portions of the second (708) and third (715) sacrificial layers structured between the faces facing each other of the first (706) and second (708) active layers and between the second (710) and third (715) active layers,
k') at least partially eliminating the first sacrificial layer (704) releasing the mobile part.

3. The process for producing a micromechanical structure as claimed in Claim 2, in which during step c'), the first portion (708') of the second sacrificial layer (708) comprises a surface lower than that of the second portion (708''), the first portion (708') having a surface near the section of the portion of second sacrificial layer (708) passing through the first active layer (706).

4. The process for producing a micromechanical structure as claimed in any one of Claims 1 to 3, in which the material of the second layer and/or of the third sacrificial layer is oxide.

5. The process for producing a micromechanical structure as claimed in any one of Claims 1 to 4, in which the second active layer and/or of the third active layer is formed by epitaxial growth.

6. The process for producing a micromechanical structure as claimed in any one of Claims 1 to 5, in which each of the active layers of the stack is silicon or SiGe.

7. The process for producing a micromechanical structure as claimed in any one of Claims 1 to 6, in which the first sacrificial layer (604, 704) is silicon oxide, and forms part of a SOI substrate.

8. The micromechanical structure produced by the process as claimed in any one of Claims 1 to 7, comprising a substrate (2; 802) and a stack (4; 804) of at least a first and a second layers (4.1, 4.2; 801.1, 802.2) arranged on the substrate (2; 802), a mobile part (8; 808) formed in the stack (4; 804) and a fixed part (10; 810) relative to the substrate (2; 802) formed in the stack (4; 804), the mobile part (8; 808) comprising portions of said at least first and second layers (4.1, 4.2; 807.1, 807.2) of said stack (4; 804) and the fixed part (10; 810) comprising portions of said at least first and second layers (4.1, 4.2; 807.1, 807.2) of said stack (4; 804), the fixed part (10; 810) and the mobile part (8; 808) comprising a first and a second surface (18.1, 18.2, 20.1, 20.2; 812.1, 812.2, 814.1, 814.2) facing each other substantially parallel to a medium plane of the structure (2, 802), said first surface (18.1, 20.1; 812.2, 814.1) being formed in the first layer (4.1; 807.1) of the stack and said second surface (18.2, 20.2; 812.1, 814.2) being formed in the second layer (4.2; 807.2) of the stack,
said first and second layer (18.1, 18.2, 20.1, 20.2; 812.1, 812.2, 814.1, 814.2) facing each other being configured to form stops or electrodes, in which said stops or electrodes are formed by the first surface (20.1; 812.2) of the fixed part (10; 810) and the second surface (20.2; 814.2) of the mobile part (8; 808), and/or by the second surface (18.2; 812.1) of the fixed part (10; 810) and the first surface (18.1; 814.1) of the mobile part (8; 808),
and a material (11; 811) being interposed between the fixed part (10; 810) and the substrate (2; 802), said material (11; 811) being different to that or those of the layers (4.1, 4.2; 807.1, 807.2) of the stack (4; 804) forming the fixed (10; 810) and mobile (8; 808) parts, said material (11; 811) able to be etched selectively relative to that or to those of the layers (4.1, 4.2; 807.1, 807.2) of the stack (4; 804).

9. The micromechanical structure as claimed in Claim 8, in which the stack comprises a first and a second pair of faces facing each other, the face of the first pair belonging to the mobile part being in the same plane as the face of the second pair belonging to the fixed part and the face of the first pair belonging to the fixed part being in the same plane as the face of the second pair belonging to the mobile part.

10. The micromechanical structure as claimed in Claim 8 or 9, in which, in normal operation, the mobile part is intended to move in a direction orthogonal to the medium plane of the structure and in which the faces facing each other of the fixed and mobile parts form electrodes, the fixed part and the mobile part being at different potentials.

11. The micromechanical structure as claimed in any one of Claims 8 or 9, in which, in normal operation, the mobile part is intended to move in the medium plane of the structure and in which the faces facing each other of the fixed and mobile parts form stop means (16, 116, 216, 316, 416, 516) to limit displacement of the mobile part (8, 108, 208, 308, 408, 508) in a direction substantially perpendicular to the stack (4, 104, 204, 304, 404, 504).

12. The micromechanical structure as claimed in Claim 11, in which the stack (4, 104, 204, 304, 404, 504) comprises at least one first layer to the side of the substrate and a second layer on the first layer opposite the substrate (2, 102, 202, 302, 402, 502), and in which the stop means (16, 116, 216, 316, 416, 516) comprise at least one lower stop to limit displacement of the mobile part to the substrate and/or at least one upper stop to limit displacement of the mobile part (8, 108, 208, 308, 408, 508) opposite the substrate, the lower stop being defined in the first layer of the fixed part (10, 110, 210, 310, 410, 510) and in the second layer of the mobile part (8, 108, 208, 308, 408, 508) and the upper stop being defined in the second layer of the fixed part (10, 110, 210, 310, 410, 510) and in the first layer of the mobile part (8, 108, 208, 308, 408, 508).

13. The micromechanical structure as claimed in Claim 11 or 12, in which the lower stop comprises a surface in the first layer of the fixed part (10, 110, 210, 310, 410, 510) and a surface in the second layer of the mobile part (8, 108, 208, 308, 408, 508), the two surfaces facing each other and the upper stop comprises a surface in the second layer of the fixed part (10, 110, 210, 310, 410, 510) and a surface in the first layer of the mobile part (8, 108, 208, 308, 408, 508), the two surfaces facing each other.

14. The micromechanical structure as claimed in any one of Claims 11 to 13, in which the stack (504) comprises at least one first (504.1), a second (504.2) and a third (504.3) layer, and in which the stop means (516) comprise at least one lower stop (520) to limit displacement of the mobile part (508) to the substrate (502) and/or at least one upper stop (518) to limit displacement of the mobile part (508) opposite the substrate (502), the lower stop (520) being defined in the first layer (504.1) of the fixed part (510) and in the second layer (504.2) of the mobile part (508) and the upper stop (518) being defined in the second layer (504.2) of the mobile part (508) and in the third layer (504.3) of the fixed part (510).

15. The micromechanical structure as claimed in any one of Claims 11 to 14, in which the fixed part (110) comprises at least three fingers (132.1, 132.2, 132.3), and the mobile part (108) comprises at least three fingers (128.1, 128.2, 128.3), the fingers (132.1, 132.2, 132.3) of the fixed part (110) and those (128.1, 128.2, 128.3) of the mobile part (108) being interdigitated, in which the upper stop (118) is formed by one (128.1) of the fingers of the mobile part (108) received between two fingers (132.1, 132.2) of the fixed part (110), said finger (128.1) comprising two lateral elements (134) each bearing a surface of the upper stop, each lateral element (134) being received in a housing of complementary form formed by the two fingers (132.1, 132.2) of the fixed part (110) on either side of said finger (128.1) of the mobile part (108), the bottom of these housings forming the surface facing the upper stop (118), and in which the lower stop (120) is formed by one of the fingers (132.3) of the fixed part (110) received between two fingers (128.2, 128.3) of the mobile part (108), said finger (132.3) comprising two lateral elements (136) each bearing a surface, each lateral element (136) being received in a housing of complementary form formed by the two fingers (128.2, 128.3) of the mobile part (108) on either side of said finger (132.3) of the fixed part (110), the bottom of these housings forming the facing surface.

16. The micromechanical structure as claimed in any one of Claims 11 to 15, in which the fixed part (210, 310) comprises a face parallel to a face of the mobile part (208, 308) and facing said face, said faces being substantially orthogonal to the plane of the structure, each face comprising at least one projecting finger (238, 244, 338, 344), the finger (238, 338) of the mobile part (208, 308) being received in a housing (240, 340) of the fixed part (210, 310) of corresponding form and the finger (244, 344) of the fixed part (210, 310) being received in a housing (246, 346) of the mobile part (208, 308) of corresponding form.

17. The micromechanical structure as claimed in any one of Claims 11 to 16, comprising stops to limit displacement of the mobile part in the plane, called lateral stops, and/or in which the housings also form said lateral stops.

18. The micromechanical structure as claimed in Claim 10, in which the mobile part (808) comprises at least one mobile mass and two beams (818.1, 818.2) on either side of the mobile mass to which the mobile mass is connected by segments, the beam bearing the electrodes, each of the beams cooperating with a sub-part of the fixed part (810) bearing the electrodes facing each other.

19. The micromechanical structure as claimed in Claim 10, in which the mobile part (908) comprises a first and a second electrode arranged side by side and the fixed part (910) comprises a first and a second electrode arranged side by side, each facing an electrode of the mobile part (908), the first electrode of the mobile part (908) being made in the first layer and the first electrode of the fixed part being made in the second layer facing the first electrode of the mobile part (908), and the second electrode of the mobile part (908) being made in the second layer and the second electrode of the fixed part (910) being made in the first layer facing the second electrode of the mobile part (908).

20. The micromechanical structure as claimed in Claim 19, in which the mobile part (908) has an elongated form whereof a first longitudinal end is mounted on a torsion axis orthogonal to the axis of the mobile part (908) and whereof a second end bears the electrodes.

21. The micromechanical structure as claimed in Claim 10, in which, given that the medium plane of the structure, the mobile part (1008) comprises a housing formed by a notch of rectangular form made in an edge of the mobile part (1008), the fixed part (1010) being received in this notch and having a form corresponding to that of the notch, its lateral edges facing the lateral edges of the mobile part (1008), the electrodes being carried by the lateral edges of the notch and of the mobile electrode (1008), the mobile part (1008) being intended to move in a direction substantially orthogonal to the lateral edges.

22. The micromechanical structure as claimed in any one of Claims 10, 18 to 21, in which the electrodes are carried by interdigitated fingers made in the first or the second layer.

23. A sensor comprising at least one micromechanical structure as claimed in any one of Claims 8 to 22.
